# EUROPEAN PATENT APPLICATION

(11) **EP 4 715 872 A1**
(43) Date of publication of application: **25.03.2026**
(21) Application number: 25189871.4
(22) Date of filing: 16.07.2025
(51) Int. Cl.: H01L 23/13, H01L 23/15, H01L 21/48, H01L 23/538, H01L 25/16, H01L 23/00

(54) **INTEGRATED CIRCUIT PACKAGES INCLUDING A GLASS-CORE SUBSTRATE**

(30) Priority: 18.09.2024 US 202418888519
(71) Applicant: Intel Corporation, Santa Clara, CA 95054 (US)
(72) Inventor: Ecton, Jeremy, Gilbert, 85298 (US); Nad, Suddhasattwa, Chandler, 85249 (US); Mohammadighaleni, Mahdi, Phoenix, 85048 (US); Duan, Gang, Chandler, 85248 (US); Pietambaram, Srinivas Venkata Ramanuja, Chandler, 85249 (US); Marin, Brandon C., Gilbert, 85234 (US); Stacey, Joshua, Chandler, 85226 (US); Heaton, Thomas S., Mesa, 85204 (US); Kaviani, Shayan, Phoenix, 85048 (US); Zamani, Ehsan, Phoenix, 85044 (US); Tavakoli, Elham, Phoenix, 85048 (US); Wall, Marcel Arlan, Phoenix, 85048 (US); Grujicic, Darko, Chandler, 85249 (US)
(74) Representative: Goddar, Heinz J.

(57) **Abstract**

Disclosed herein are microelectronic assemblies and related devices and methods. In some embodiments, a microelectronic assembly may include a first layer having a first dielectric, a third dielectric, and a first glass portion between the first dielectric and the third dielectric; a second layer having a second dielectric, a fourth dielectric, and a second glass portion between the second dielectric and the fourth dielectric; and a third layer between the first layer and the second layer, the third layer having a bulk glass material, and wherein the first layer physically couples to a first surface of the third layer and the second layer physically couples to a second surface of the third layer.

## Description

### BACKGROUND

For the past several decades, scaling of features in integrated circuits (ICs) has been a driving force behind an ever-growing semiconductor industry and emerging applications in fields such as big data, artificial intelligence, mobile communications, and autonomous driving. Scaling to smaller and smaller features enables increased densities of functional units on the limited real estate of semiconductor chips. For example, shrinking transistor size allows incorporation of an increased number of memory or logic devices on a chip, lending to the fabrication of products with increased capacity. The drive for the ever-increasing capacity, however, is not without issue. The necessity to optimize fabrication and performance of each component (e.g., of each transistor) is becoming increasingly significant.

Parallel to optimizations at the transistor level, advanced IC packaging landscape is rapidly evolving to accommodate performance expectations and requirements of shrinking transistor size. Multiple IC dies are now commonly coupled together in a multi-die IC package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass cores have been explored as alternatives to organic resin-based cores (e.g., cores based on using build-up films). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties. However, a major challenge for widespread adoption of glass cores is the fact that glass is highly susceptible to damage due to mechanical and/or thermal stresses.

### BRIEF DESCRIPTION OF THE DRAWINGS

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 is a schematic cross-sectional view of an example microelectronic assembly according to some embodiments of the present disclosure.
FIGS. 2A-2E are schematic cross-sectional views of other example microelectronic assemblies according to some embodiments of the present disclosure.
FIGS. 3A-3C are schematic top views of example microelectronic assemblies according to some embodiments of the present disclosure.
FIGS. 4A and 4B are schematic cross-sectional views of other example microelectronic assemblies according to some embodiments of the present disclosure.
FIGS. 5A-5D are schematic cross-sectional views of other example microelectronic assemblies according to some embodiments of the present disclosure.
FIGS. 6A-6D are simplified cross-sectional views illustrating various manufacturing steps of an example microelectronic assembly according to some embodiments of the present disclosure.
FIGS. 7A-7D are simplified cross-sectional views illustrating various manufacturing steps of another example microelectronic assembly according to some embodiments of the present disclosure.
FIGS. 8A and 8B are simplified cross-sectional views illustrating various manufacturing steps of yet another example microelectronic assembly according to some embodiments of the present disclosure.
FIGS. 9A-9D are simplified cross-sectional views illustrating various manufacturing steps of yet another example microelectronic assembly according to some embodiments of the present disclosure.
FIGS. 10A-10H are simplified cross-sectional views illustrating various manufacturing steps of yet another example microelectronic assembly according to some embodiments of the present disclosure.
FIGS. 11A-11H are simplified top views of the various manufacturing steps of FIGS. 10A-10H according to some embodiments of the present disclosure.
FIGS. 12A-12C are simplified cross-sectional views illustrating various manufacturing steps of yet another example microelectronic assembly according to some embodiments of the present disclosure.
FIGS. 13A-13C are simplified cross-sectional views illustrating various manufacturing steps of yet another example microelectronic assembly according to some embodiments of the present disclosure.
FIGS. 14A-14D are simplified cross-sectional views illustrating various manufacturing steps of yet another example microelectronic assembly according to some embodiments of the present disclosure.
FIG. 15 is a cross-sectional view of a device package that may include one or more microelectronic assemblies in accordance with any of the embodiments disclosed herein.
FIG. 16 is a cross-sectional side view of a device assembly that may include one or more microelectronic assemblies in accordance with any of the embodiments disclosed herein.
FIG. 17 is a block diagram of an example computing device that may include one or more microelectronic assemblies in accordance with any of the embodiments disclosed herein.

### DETAILED DESCRIPTION

The structures and assemblies disclosed herein may include a glass core, also referred to herein as a "glass layer," with through-glass vias (TGVs) extending through the glass core for front-to-back connections between two different substrates. A substrate may include a dielectric material with conductive pathways therein that are typically formed on a surface of the glass core. The conductive pathways through the dielectric material may provide routing for design flexibility, and the uniform diameters of the TGVs may provide dimensional stability and improved connectivity. A glass core as compared to a conventional epoxy core offers several advantages including higher through-glass via (TGV) density, lower signal losses, and lower total thickness variation (TTV), among others. Another advantage is a glass core enables higher aspect ratio TGVs. Higher aspect ratio TGVs are required to achieve the finer pitches that are desired.

As mentioned above, a major challenge for widespread adoption of glass cores is the fact that glass is highly susceptible to damage due to mechanical and/or thermal stresses. One source of mechanical and thermal stresses in glass is singulation process (sometimes referred to as "dicing" or "cutting") that takes place during manufacturing of glass cores. Singulation is a process in which a cutting tool (e.g., a glass cutter, a diamond blade, or a saw) applies mechanical force to the surface of a glass panel in order to separate (e.g., dice or cut) the panel into individual glass units having a smaller form factor than the panel. The mechanical force applied by the cutting tool may create a localized stress concentration (e.g., regions of higher stress) at or near the surfaces where the cutting tool contacts the glass, e.g., at or near the edges of the individual glass units, where, as used herein, the term "edge" refers to a side/sidewall that is between top and the bottom faces of a glass unit, a glass core, or glass panel. Because glass is a brittle material characterized by its lack of ductility (e.g., characterized by its limited ability to undergo significant plastic deformation before fracturing), localized stress concentration often leads to formation of cracks at the edges of singulated glass units. Besides imposing mechanical stress onto glass, singulation can also generate thermal stress due to friction between the cutting tool and glass, heating up the surface being cut. The heat can cause localized expansion and contraction of glass, further promoting crack formation and propagation.

Singulation is not the only source of stress and damage that may affect glass cores. Presence of materials with different CTEs on top and/or on the bottom of glass cores (e.g., metals of conductive pathways and/or dielectric materials of build-up layers) adds to the stresses in glass (such stresses referred to as "CTE mismatch-induced stresses"), further exacerbating the problem of crack formation. Even if cracks don't form immediately during singulation, cutting of brittle materials like glass often results in individual glass units with edges that are rough, jagged, or otherwise uneven. Repeated thermal cycling during operation of microelectronic assemblies that include glass cores with such edges can gradually weaken the glass surface due to CTE mismatch-induced stresses, leading to formation of cracks at that time. Furthermore, even before singulation, glass may have tiny surface flaws or defects, which can act as initiation points for crack formation, with additional mechanical and/or thermal stresses increasing the severity of crack growth.

Once cracks start to form, they tend to propagate through glass, with additional mechanical and/or thermal stresses increasing the severity of crack propagation. In particular, the stress concentration at the edges of the glass units encourages the cracks to extend further into glass, and the inherent brittleness of glass makes it particularly susceptible to crack propagation. Propagation of cracks may even cause a glass volume to split into two halves around a plane parallel to the top/bottom surfaces of the glass volume and being about in the middle of the glass volume, one half being the bottom half and the other half being the top half of what is supposed to be a single structure.

As the foregoing illustrates, crack formation and propagation in glass compromises the structural integrity of glass, making microelectronic assemblies with glass cores particularly prone to failure over time. Embodiments of the present disclosure relate to various techniques, as well as to related devices and methods, for alleviating (e.g., mitigating or reducing) crack formation and propagation in glass. In particular, embodiments of the present disclosure are based on providing various edge features during or after singulation of a glass panel into individual glass units. Various ones of the embodiments disclosed herein may achieve singulation without breakage, may help reduce the cost and complexity assembling multi-die IC packages relative to conventional approaches, and may further increase reliability and functionality of these IC packages during use.

Accordingly, disclosed herein are microelectronic assemblies and related devices and methods. In some embodiments, a microelectronic assembly may include a glass layer having a first surface and an opposing second surface, the glass layer having a first cavity in the first surface; a second cavity in the second surface; and a through-glass via (TGV) extending through the glass layer between a top surface of the first cavity and a bottom surface of the second cavity, the TGV including a conductive material; a first dielectric in the first cavity, the first dielectric including a first conductive pathway electrically coupled to the TGV; and a second dielectric in the second cavity, the second dielectric including a second conductive pathway electrically coupled to the TGV. In some embodiments, a microelectronic assembly may include a first layer having a first dielectric, a third dielectric, and a first glass portion between the first dielectric and the third dielectric; a second layer having a second dielectric, a fourth dielectric, and a second glass portion between the second dielectric and the fourth dielectric; and a third layer between the first layer and the second layer, the third layer having a bulk glass material, and wherein the first layer physically couples to a first surface of the third layer and the second layer physically couples to a second surface of the third layer.

Each of the structures, assemblies, packages, methods, devices, and systems of the present disclosure may have several innovative aspects, no single one of which is solely responsible for all the desirable attributes disclosed herein. Details of one or more implementations of the subject matter described in this specification are stated in the description below and the accompanying drawings.

In the following detailed description, various aspects of the illustrative implementations may be described using terms commonly employed by those skilled in the art to convey the substance of their work to others skilled in the art.

The terms "circuit" and "circuitry" mean one or more passive and/or active electrical and/or electronic components that are arranged to cooperate with one another to provide a desired function. The terms also refer to analog circuitry, digital circuitry, hard wired circuitry, programmable circuitry, microcontroller circuitry and/or any other type of physical hardware electrical and/or electronic component.

The term "integrated circuit" means a circuit that is integrated into a monolithic semiconductor or analogous material.

In some embodiments, the IC dies disclosed herein may include substantially monocrystalline semiconductors, such as silicon or germanium, as a base material on which integrated circuits are fabricated with traditional semiconductor processing methods. The semiconductor base material may include, for example, N-type or P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may include alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may include compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may include an intrinsic IV or III-V semiconductor material or alloy, not intentionally doped with any electrically active impurity; in alternate embodiments, nominal impurity dopant levels may be present. In still other embodiments, dies may include a non-crystalline material, such as polymers; for example, the base material may include silica-filled epoxy. In other embodiments, the base material may include high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

Unless described otherwise, IC dies described herein include one or more IC structures (or, simply, "ICs") implementing (i.e., configured to perform) certain functionality. In one such example, the term "memory die" may be used to describe a die that includes one or more ICs implementing memory circuitry (e.g., ICs implementing one or more of memory devices, memory arrays, control logic configured to control the memory devices and arrays, etc.). In another such example, the term "compute die" may be used to describe a die that includes one or more ICs implementing logic/compute circuitry (e.g., ICs implementing one or more of input/output (I/O) functions, arithmetic operations, pipelining of data, etc.).

In another example, the terms "package" and "IC package" are synonymous, as are the terms "die" and "IC die." Note that the terms "chip," "chiplet," "die," and "IC die" are used interchangeably herein.

The term "optical structure" includes arrangements of forms fabricated in ICs to receive, transform and/or transmit optical signals as described herein. It may include optical conductors such as waveguides, electromagnetic radiation sources such as lasers and light-emitting diodes (LEDs) and electro-optical devices such as photodetectors.

In various embodiments, any photonic IC (PIC) described herein may include a semiconductor material, for example, N-type or P-type materials. The PIC may include, for example, a crystalline base material formed using a bulk silicon (or other bulk semiconductor material) or a SOI structure (or, in general, a semiconductor-on-insulator structure). In some embodiments, the PIC may be formed using alternative materials, which may or may not be combined with silicon, that include, but are not limited to, lithium niobite, indium phosphide, silicon dioxide, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-N or group IV materials. In some embodiments, the PIC may include a non-crystalline material, such as polymers. In some embodiments, the PIC may be formed on a printed circuit board (PCB). In some embodiments, the PIC may be inhomogeneous, including a carrier material (such as glass or silicon carbide) as a base material with a thin semiconductor layer over which is an active side comprising transistors and like components. Although a few examples of the material for the PIC are described here, any material or structure that may serve as a foundation upon which the PIC may be built falls within the spirit and scope of the present disclosure.

The term "insulating" means "electrically insulating," the term "conducting" means "electrically conducting," unless otherwise specified. With reference to optical signals and/or devices, components and elements that operate on or using optical signals, the term "conducting" can also mean "optically conducting."

The terms "oxide," "carbide," "nitride," etc. refer to compounds containing, respectively, oxygen, carbon, nitrogen, etc.

The term "high-k dielectric" refers to a material having a higher dielectric constant than silicon oxide, while the term "low-k dielectric" refers to a material having a lower dielectric constant than silicon oxide.

The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In various embodiments of the present disclosure, transistors described herein may be field-effect transistors (FETs), e.g., metal oxide semiconductor (MOS) FETs (MOSFETs). In general, a FET is a three-terminal device that includes source, drain, and gate terminals and uses electric field to control current flowing through the device. A FET typically includes a channel material, a source region and a drain regions provided in and/or over the channel material, and a gate stack that includes a gate electrode material, alternatively referred to as a "work function" material, provided over a portion of the channel material (the "channel portion") between the source and the drain regions, and optionally, also includes a gate dielectric material between the gate electrode material and the channel material.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are included in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a PIC, "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The term "waveguide" refers to any structure that acts to guide the propagation of light from one location to another location typically through a substrate material such as silicon or glass. In various examples, waveguides can be formed from silicon, doped silicon, silicon nitride, glasses such as silica (e.g., silicon dioxide or SiO2), borosilicate (e.g., 70-80 wt% SiO2, 7-13 wt% of B2O3, 4-8 wt% Na2O or K2O, and 2-8 wt% of Al2O3) and so forth. Waveguides may be formed using various techniques including but not limited to forming waveguides in situ. For example, in some embodiments, waveguides may be formed in situ in glass using low temperature glass-to-glass bonding or by laser direct writing. Waveguides formed in situ may have lower loss characteristics.

The term "conductive trace" may be used to describe an electrically conductive element isolated by an insulating material. Within IC dies, such insulating material includes interlayer low-k dielectric that is provided within the IC die. Within package substrates, and printed circuit boards (PCBs) such insulating material includes organic materials such as a build-up film, polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate, the term "interconnect" may also refer to, respectively, die-to-die (DTD) interconnects and die-to-package substrate (DTPS) interconnects. DTD interconnects may also be referred to as first-level interconnects (FLI). DTPS interconnects may also be referred to as Second-Level Interconnects (SLI). Although not specifically shown in all of the present illustrations in order to not clutter the drawings, when DTD or DTPS interconnects are described, a surface of a first die may include a first set of conductive contacts, and a surface of a second die or a package substrate may include a second set of conductive contacts. One or more conductive contacts of the first set may then be electrically and mechanically coupled to some of the conductive contacts of the second set by the DTD or DTPS interconnects. In some embodiments, the pitch of the DTD interconnects may be different from the pitch of the DTPS interconnects, although, in other embodiments, these pitches may be substantially the same.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may include the same or different insulating materials. In some embodiments, the levels of underfill may include thermoset epoxies with silicon oxide particles; in some embodiments, the levels of underfill may include any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, glass transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable dielectrics, dry film photoimageable dielectrics, acrylics, solvents) may be provided in an IC package described herein and may not be labeled or shown to avoid cluttering the drawings. Solder resist may be a liquid or dry film material including photoimageable dieletrics. In some embodiments, solder resist may be non-photoimageable.

The terms "substantially," "close," "approximately," "near," and "about," generally refer to being within +/- 20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments.

Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used herein, the notation "A/B/C" means (A), (B), and/or (C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale.

Coordinates, when included in the accompanying drawings, identify a thickness or a height by z-dimension, a width by y-dimension, and a length by x-dimension. A diameter, cross section, or surface area may be identified by xy-dimension.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or non-contact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects) are shown as aligned (e.g., at respective interfaces) merely for ease of illustration; in actuality, some or all of them may be misaligned. In addition, there may be other components, such as bond-pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

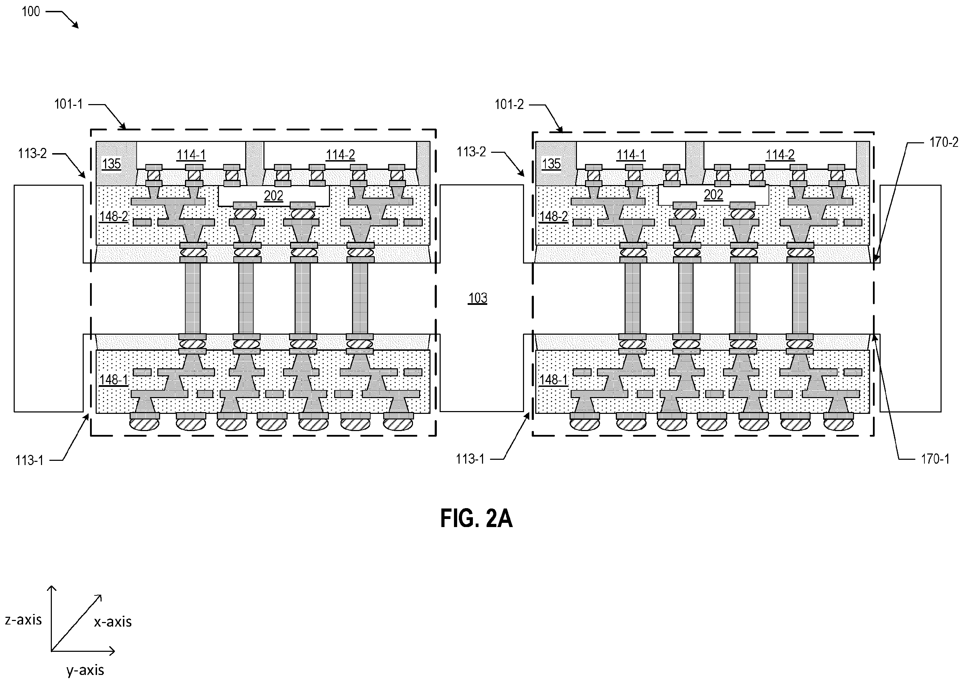

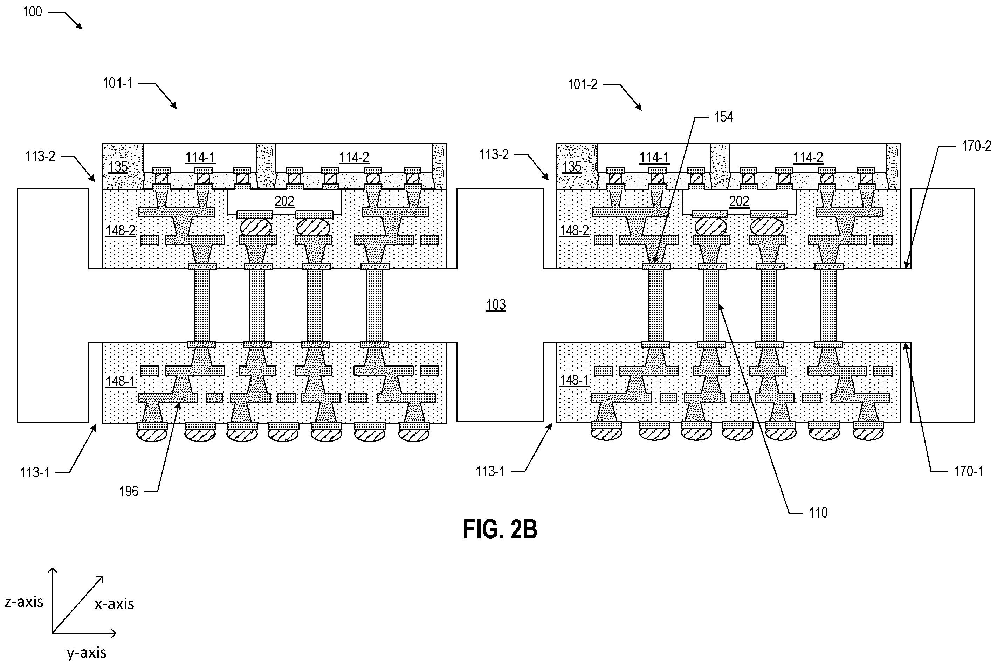

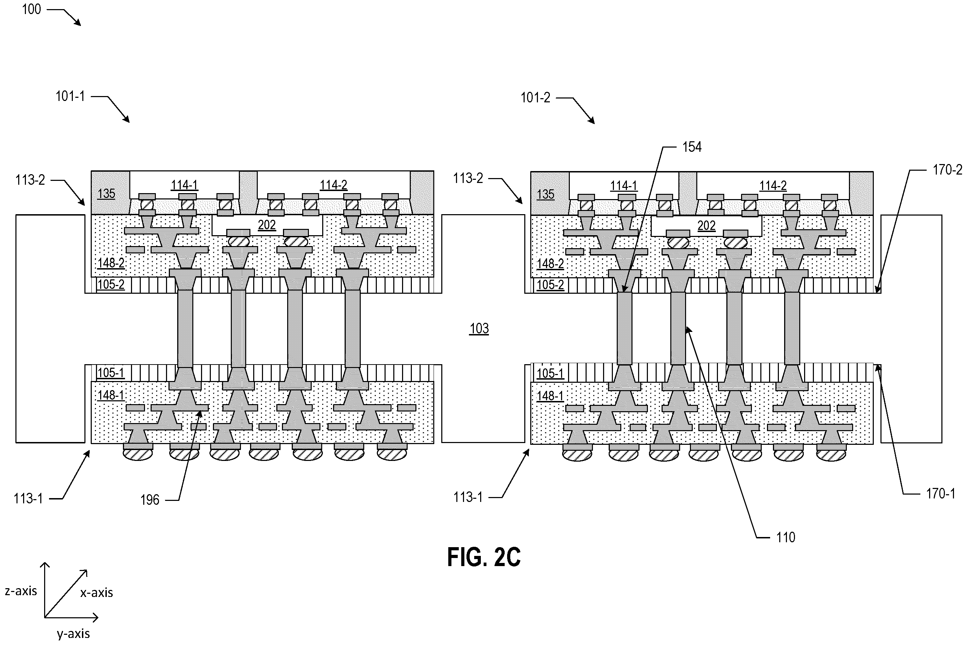

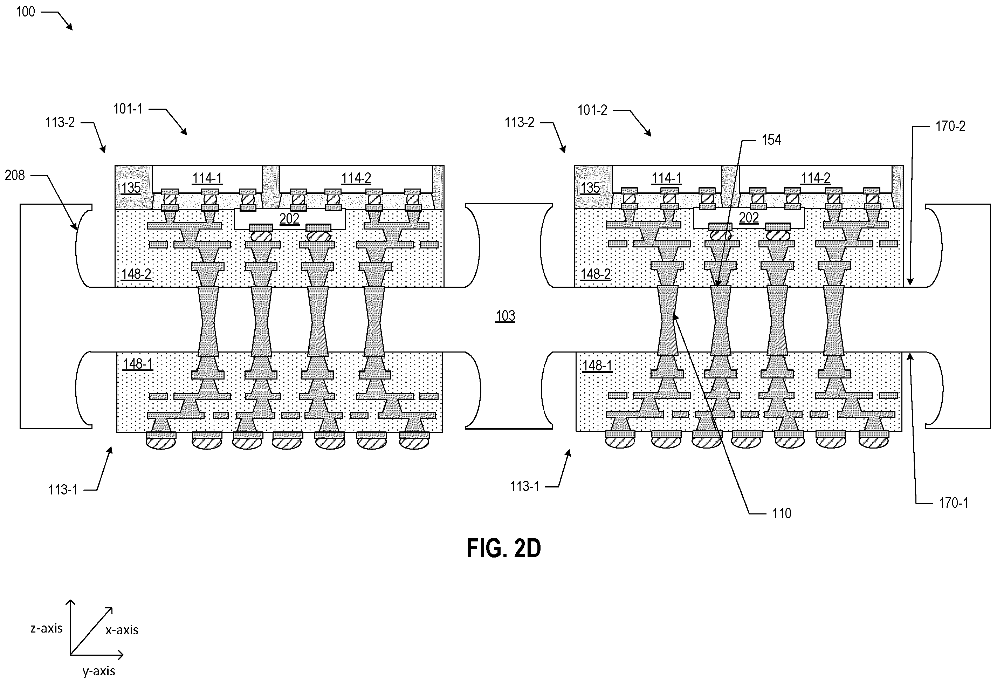

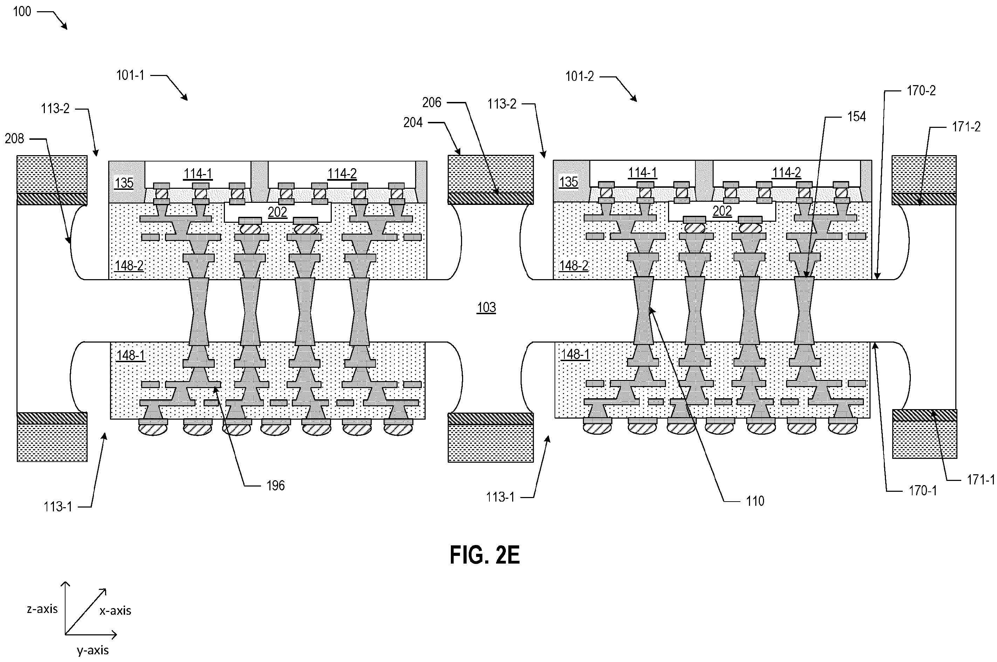

For convenience, if a collection of drawings designated with different letters are present (e.g., FIGS. 2A-2E), such a collection may be referred to herein without the letters (e.g., as "FIG. 2"). Similarly, if a collection of reference numerals designated with different numbers and/or letters are present (e.g., 148-1, 148-2), such a collection may be referred to herein without the numbers (e.g., as "148").

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

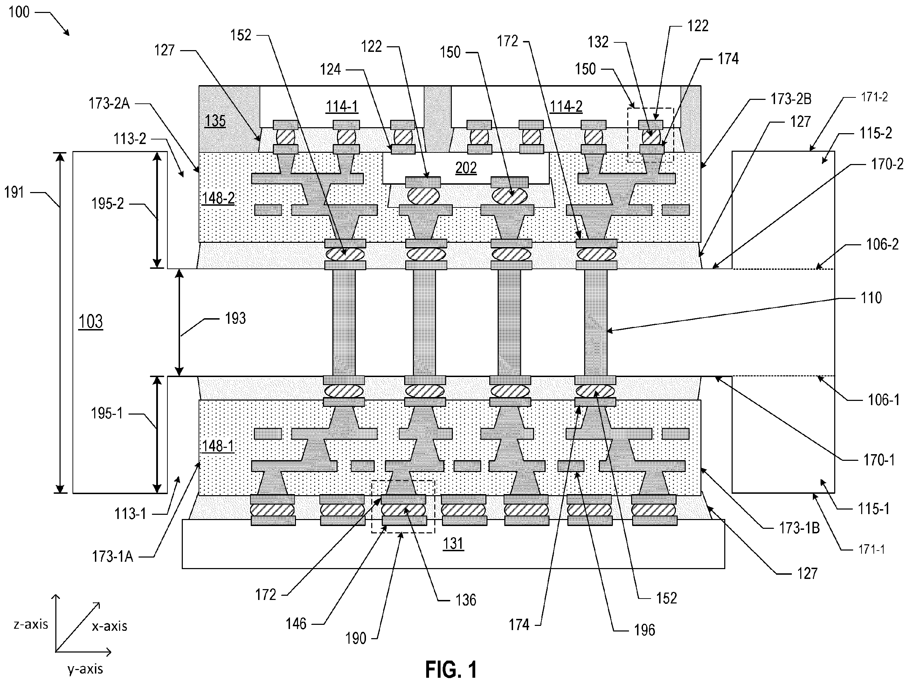

FIG. 1 is a schematic cross-sectional view of an example microelectronic assembly 100 according to some embodiments of the present disclosure. Microelectronic assembly 100 may include a core 103 having a first cavity 113-1 at a bottom surface 171-1 (e.g., a top of the cavity 113-1 is at a first surface 170-1 of the core 103), a second cavity 113-2 at an opposing top surface 171-2 (e.g., a bottom of the cavity 113-2 is at a second surface 170-2 of the core 103), a first substrate 148-1 at least partially within the first cavity 113-1 (e.g., at least partially nested in a cavity of the core 103 such that a portion of the core 103 extends at least partially along lateral surfaces 173-1A, 173-1B of the first substrate 148-1), and a second substrate 148-2 at least partially within the second cavity 113-2 (e.g., at least partially nested in a cavity of the core 103 such that a portion of the core 103 extends at least partially along lateral surfaces 173-2A, 173-2B of the second substrate 148-2). The first and second substrates 148-1, 148-2 may include conductive pathways 196 (e.g., including conductive traces and/or conductive vias, as shown) through a dielectric material. The substrates 148 may include a set of first conductive contacts 172 at the bottom surface of the substrate 148 and a set of second conductive contacts 174 at the top surface of the substrate 148, where the conductive pathways 196 electrically couple individual ones of the first and second conductive contacts 172, 174. The microelectronic assembly 100 may further include through-glass vias (TGVs) 110 in the core 103 that electrically couple the first substrate and the second substrate 148-1, 148-2. TGVs 110 may have any suitable size and shape. A thickness 193 of the individual TGVs 110 may be between 50 microns and 2 millimeters (i.e., between 50 microns and 1 millimeter). A diameter (e.g., xy-dimension) of the individual TGVs 110 may be between 5 microns and 100 microns (e.g., between 20 microns and 50 microns). TGVs 110 are shown in FIG. 1 as having straight, parallel sides; however, in various embodiments, the sides may be tapered, tapered towards a center (e.g., have an hourglass shape, as shown in FIGS. 2D and 2E), and/or have other irregularities depending on the processing conditions for generating TGVs 110. TGVs 110 may be formed using any suitable process, including, for example, laser drilling via openings through the core 103 and depositing a conductive material in the openings. TGVs 110 may be formed of any suitable conductive material, such as copper, silver, nickel, gold, aluminum, or other metals or alloys. In some embodiments, a pitch of the TGVs 110 may be between 25 microns and 200 microns (e.g., between 75 microns and 150 microns). The conductive pathways 196 of the first and second substrates 148-1, 148-2 may be conductively coupled to the TGVs 110 by interconnects 152, which may include solder.

The first and second substrates 148-1, 148-2 may be manufactured using any suitable technique, such as a semi-additive process, a subtractive etching technique, or other conventional substrate package techniques. In some embodiments, a dielectric material of the substrate 148 may include bismaleimide triazine (BT) resin, polyimide materials, epoxy materials (e.g., glass reinforced epoxy matrix materials, epoxy build-up films, or the like), mold materials, oxide-based materials (e.g., silicon dioxide or spin on oxide), or low-k and ultra low-k dielectric (e.g., carbon-doped dielectrics, fluorine-doped dielectrics, porous dielectrics, and organic polymeric dielectrics). As used herein, the core 103 with the second substrate 148-2 and/or the first substrate 148-1 may be referred to as a package substrate. TGVs 110 in core 103 may enable power, ground and signal connectivity to components located on either side of the core 103, for example, between dies 114-1, 114-2 and a circuit board 131.

A material of the core 103 may include glass, such as bulk transparent glass, and also may be referred to herein as "a glass layer." As used herein, the term "core" refers to a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the core 103 may be bulk glass or a solid volume/layer of glass, as opposed to, e.g., materials that may include particles of glass, such as glass fiber reinforced polymers. Such glass materials are typically non-crystalline, often transparent, amorphous solids. In some embodiments, the core 103 may be an amorphous solid glass layer. In some embodiments, the core 103 may include silicon and oxygen, as well as any one or more of aluminum, boron, magnesium, calcium, barium, tin, sodium, potassium, strontium, phosphorus, zirconium, lithium, titanium, and zinc. In some embodiments, the core 103 may include a material, e.g., any of the materials described above, with a weight percentage of silicon being at least about 0,5%, e.g., between about 0,5% and 50%, between about 1% and 48%, or at least about 23%. For example, if the core 103 is fused silica, the weight percentage of silicon may be about 47%. In some embodiments, the core 103 may include at least 23% silicon and/or at least 26% oxygen by weight, and, in some further embodiments, the core 103 may further include at least 5% aluminum by weight. In some embodiments, the core 103 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the core 103 may be a layer of glass that does not include an organic adhesive or an organic material. The core 103 may be distinguished from, for example, the "prepreg" or "RF4" core of a PCB substrate which typically includes glass fibers embedded in a resinous organic material such as an epoxy. In some embodiments, a cross-section of the core 103 in an xz plane, a yz plane, and/or an xy plane of an example coordinate system, shown in FIG. 1, may be substantially rectangular.

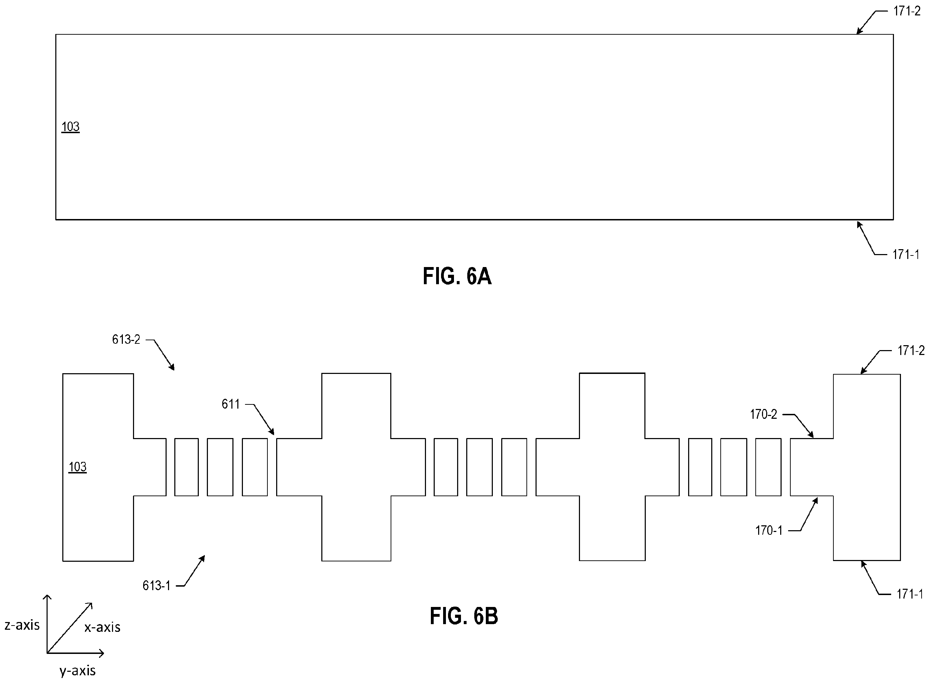

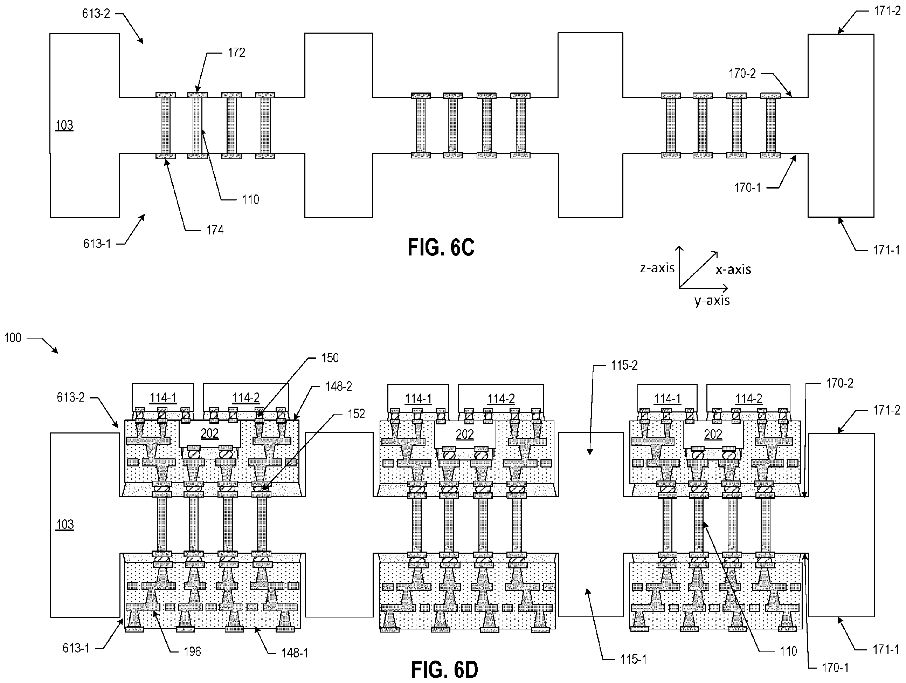

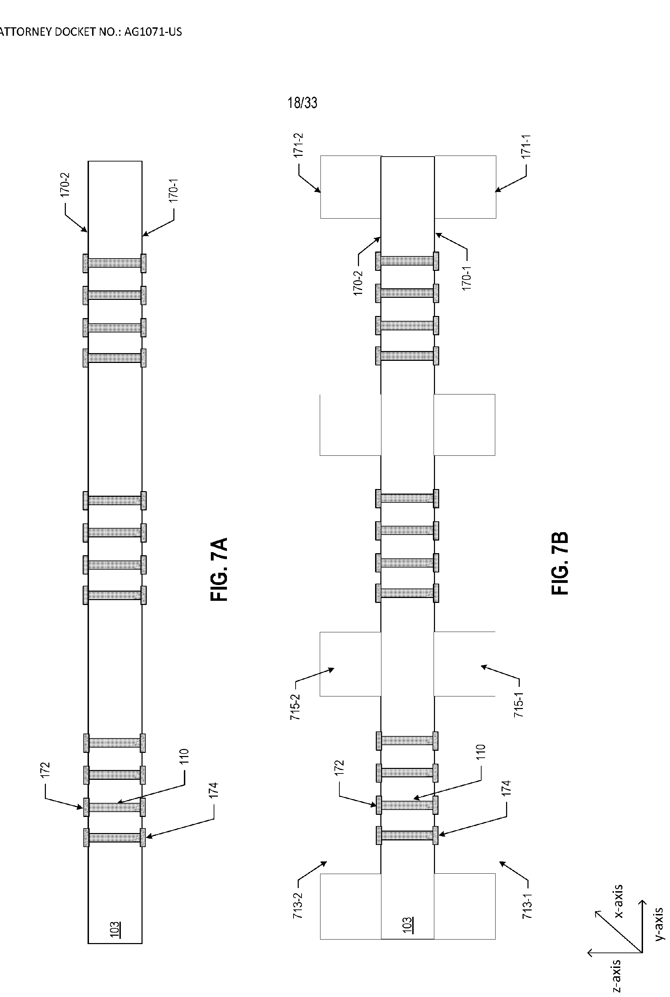

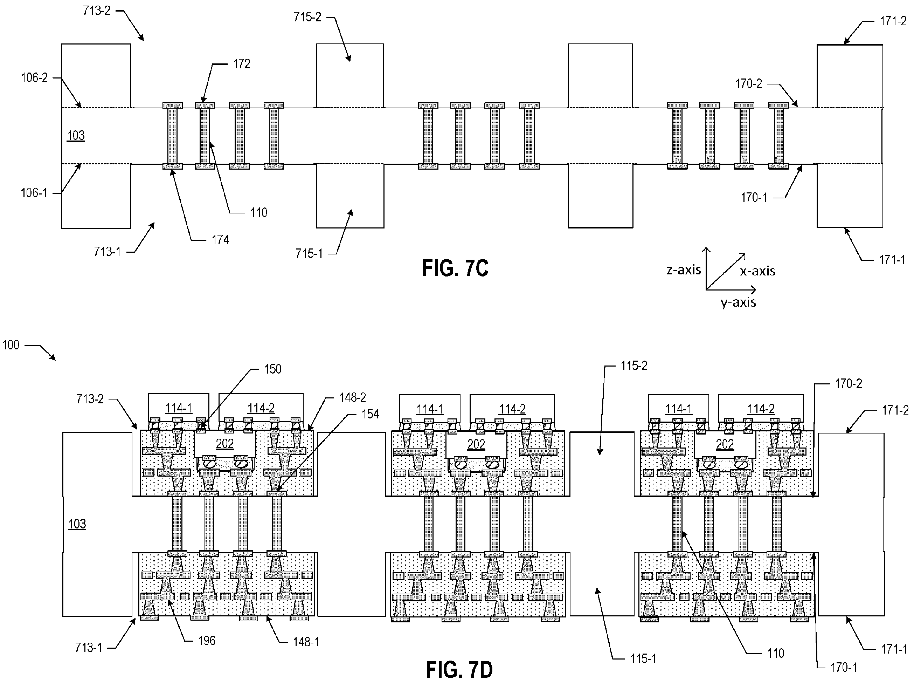

An overall thickness 191 of a core 103 may depend on a method of forming a cavity 113 in the core 103. For example, in some embodiments, when a cavity is formed by removing a material of the core 103 (e.g., as described below with reference to FIG. 6), an overall thickness 191 of a core 103 may be between 50 microns and 2 millimeters (i.e., between 100 microns and 1 millimeter). In another example, in some embodiments, when a cavity is forming by bonding 106-1, 106-2 glass portions 115-1, 115-2 to the core 103 (e.g., as described below with reference to glass portions 715 in FIG. 7), an overall thickness 191 of a core 103 may be between 150 microns and 6 millimeters (i.e., between 500 microns and 3 millimeters). In some embodiments, thicknesses 195-1, 195-2 of glass portions 115-1, 115-2 are a same length (e.g., substantially equal). In some embodiments, thicknesses 195-1, 195-2 of glass portions 115-1, 115-2 are different lengths (e.g., varying).

The microelectronic assembly 100 may further include die 114-1 and die 114-2 electrically coupled to a top surface of the second substrate 148-2 by interconnects 150. In particular, conductive contacts 122 on a bottom surface of die 114-1, 114-2 may be electrically and mechanically coupled to conductive contacts 174 at a top surface of the second substrate 148-2 by interconnects 150. Interconnects 150 may enable electrical coupling between die 114-1 and die 114-2 through conductive pathways 196 in substrate 148-2. Interconnects 150 disclosed herein may take any suitable form. In some embodiments, a set of interconnects 150 may include solder 132 (e.g., solder bumps or balls that are subject to a thermal reflow to form the interconnects 150). Interconnects 150 that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of interconnects 150 may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression. In some embodiments, interconnects 150 disclosed herein may have a pitch between about 18 microns and 75 microns. Although FIG. 1 shows dies 114-1, 114-2 electrically coupled to substrate 148-2 by interconnects 150, dies 114-1, 114-2 may be electrically coupled by any suitable interconnects and may have a pitch between 2 microns and 70 microns.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). The conductive pathways in the dies 114 may be bordered by liner materials, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked). In various embodiments, die 114 may include, or be a part of, one or more of a central processing unit (CPU), a memory device (e.g., a high-bandwidth memory device), a logic circuit, input/output circuitry, a transceiver such as a field programmable gate array transceiver, a gate array logic such as a field programmable gate array logic, of a power delivery circuitry, a III-V or a III-N device such as a III-N or III-N amplifier (e.g., GaN amplifier), Peripheral Component Interconnect Express (PCle) circuitry, Double Data Rate (DDR) transfer circuitry, or other electronic components known in the art. In some embodiments, die 114-1 and die 114-2 may include different functionalities. As used herein, the term "functionality" with reference to a die refers to one or more functions (e.g., capability, task, operation, action, instruction execution, etc.) that the die in question can perform. For example, die 114-1 may be a CPU and die 114-2 may be a Graphics Processing Unit (GPU) or memory. In other embodiments, die 114-1 and die 114-2 may include the same or similar functionalities. For example, die 114-1 and die 114-2 may each include memory.

The microelectronic assembly 100 of FIG. 1 may also include a bridge die 202 at least partially within a dielectric material of the second substrate 148-2 (e.g., at least partially nested in a cavity). The bridge die 202 may be electrically coupled to dies 114 (e.g., die 114-1 and die 114-2) by interconnects 150. In particular, conductive contacts 122 on the bottom surface of dies 114 may be electrically and mechanically coupled to the conductive contacts 124 on the top surface of the bridge die 202 by solder to form interconnects 150. A bridge die 202 may comprise appropriate circuitry on/in a semiconductor substrate to connect at silicon-interconnect speeds with a small footprint. In some embodiments, bridge die 202 may comprise active components, such as transistors and diodes in addition to bridge circuitry including metallization traces, vias and passive components for enabling electrical coupling between two ICs; in other embodiments, bridge die 202 may include bridge circuitry including metallization traces, vias and passive components for enabling electrical coupling between die 114-1 and die 114-2, and may not include active components.

The microelectronic assembly 100 of FIG. 1 may also include an overmold material 135 that encapsulates the die 114 (e.g., on and around die 114 and interconnects 150). The overmold material 135 may extend from a top surface of the second substrate 148-2 to a top surface of the die 114. In some embodiments, the overmold material 135 may be a mold material, such as an organic polymer with inorganic silicon oxide or aluminum oxide particles, a resin material, or an epoxy material. In some embodiments (not shown) other components, such as heat sinks may be coupled to microelectronic assembly 100 based on particular needs.

The microelectronic assembly 100 of FIG. 1 may also include an underfill material 127. In some embodiments, the underfill material 127 may extend between die 114-1, 114-2 and the second substrate 148-2 around the associated interconnects 150, between the core 103 and the respective first and second substrates 148-1, 148-2 around the associated interconnects 152, and/or between bridge die 202 and the second substrate around the associated interconnects 150. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering die 114-1, 114-2 to the second substrate 148-2 when forming the interconnects 150, and then polymerizes and encapsulates the interconnects 150. The underfill process may include dispensing underfill material in liquid form, allowing the material to flow and fill the interstitial gaps around interconnects 150, and subjecting the assembly to a curing process, such as baking, to solidify the material. In some embodiments, an underfill material 127 may be omitted. Although FIG. 1 shows two separate underfill 127 portions under die 114-1 and die 114-2, the underfill 127 may be a single underfill 127 under die 114-1 and die 114-2. The underfill material 127 may be selected to have a coefficient of thermal expansion (CTE) that may mitigate or minimize the stress between die 114 and the second substrate 148-2 arising from uneven thermal expansion in the microelectronic assembly 100. In some embodiments, the CTE of the underfill material 127 may have a value that is intermediate to the CTE of the second substrate 148-2 (e.g., the CTE of the dielectric material of the substrate 148) and a CTE of the insulating material of die 114. In some embodiments, a non-conductive film (NCF) may surround interconnects 152.

The microelectronic assembly 100 of FIG. 1 may also include a circuit board 131. In particular, conductive contacts 172 on a bottom surface of the first substrate 148-1 may be electrically coupled to conductive contacts 146 on a top surface of circuit board 131 by interconnects 190. Interconnects 190 disclosed herein may take any suitable form, including solder balls for a ball grid array arrangement, pins in a pin grid array arrangement or lands in a land grid array arrangement, or any of the forms described above with reference to interconnects 150. As shown in FIG. 1, in some embodiments, a set of interconnects 190 may include solder 136 (e.g., solder bumps or balls that are subject to a thermal reflow to form the interconnects 190). In some embodiments, the interconnects 190 disclosed herein may have a pitch between about 50 microns and 300 microns. In some embodiments, an underfill material 127 may extend between the first substrate 148-1 and the circuit board 131 around the associated interconnects 190. The circuit board 131 may be a motherboard, for example, and may have other components attached to it. The circuit board may include conductive pathways and other conductive contacts for routing power, ground, and signals through the circuit board, as known in the art. In some embodiments, the interconnects 190 may not couple to a circuit board 131, but may instead couple to another IC package, an interposer, or any other suitable component.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

FIG. 2A shows a schematic cross-sectional view of another example microelectronic assembly 100 according to some embodiments of the present disclosure. The configuration of the embodiment shown in the figure is like that of FIG. 1, except for differences as described further. The configuration of microelectronic assembly 100 is as described herein except that a core 103 includes a plurality of cavities 113 at the respective first and second surfaces 170-1, 170-2 having respective first and second substrates 148-1, 148-2. As shown in FIG. 2A, the first and second substrates 148-1, 148-2 and respective components (e.g., die 114, bridge die 202, and/or overmold material 135) may be referred to as a subassembly 101 (e.g., subassemblies 101-1, 101-2, respectively) and may be referred to as such in subsequent figures for simplicity and clarity.

FIG. 2B shows a schematic cross-sectional view of another example microelectronic assembly 100 according to some embodiments of the present disclosure. The configuration of the embodiment shown in the figure is like that of FIG. 2A, except for differences as described further. The configuration of microelectronic assembly 100 is as described herein except that the conductive pathways 196 of the first and second substrates 148-1, 148-2 are conductively coupled to the TGVs 110 of the core 103 by interconnects 154, which may include metal-metal interconnects, solder-metal interconnects, tin solder interconnects, among others. As shown in FIG. 2B, in some embodiments, a conductive pad or trace may be between the TGVs 110 and the conductive pathways 196. In other embodiments, as shown in FIG. 2C, the TGVs 110 and the conductive pathways 196 may be in direct physical contact with each other.

FIG. 2C shows a schematic cross-sectional view of another example microelectronic assembly 100 according to some embodiments of the present disclosure. The configuration of the embodiment shown in the figure is like that of FIG. 2B, except for differences as described further. The configuration of microelectronic assembly 100 is as described herein except that the microelectronic assembly 100 further includes a buffer material 105-1, 105-2 at respective first and second surfaces 170-1, 170-2 of the core 103 between the respective first and second substrates 148-1, 148-2. The buffer material 105 may include any suitable material including an inorganic dielectric, such as silicon oxide, or an organic dielectric, such as a polyimide. The buffer material 105 may function as an interface layer between the core 103 and the respective substrates 148-1, 148-2. In some embodiments, a dielectric material of the substrate 148 and a buffer material 105 may be a same material. In some embodiments, a thickness (e.g., z-height) of the buffer material 105 is between 0.1 micron and 50 microns.

FIG. 2D shows a schematic cross-sectional view of another example microelectronic assembly 100 according to some embodiments of the present disclosure. The configuration of the embodiment shown in the figure is like that of FIG. 2C, except for differences as described further. The configuration of microelectronic assembly 100 is as described herein except that the buffer material 105 is omitted and the microelectronic assembly 100 also includes an undercut 208 along sidewalls of the first and second cavities 113-1, 113-2 at respective first and second surfaces 170-1, 170-2 of the core 103. In some embodiments, an undercut 208 may have a width (e.g., y-dimension) between 2 microns and 20 microns and may extend along an entire depth (e.g., z-dimension) of the cavity.

FIG. 2E shows a schematic cross-sectional view of another example microelectronic assembly 100 according to some embodiments of the present disclosure. The configuration of the embodiment shown in the figure is like that of FIG. 2D, except for differences as described further. The configuration of microelectronic assembly 100 is as described herein except that the microelectronic assembly 100 further includes a conductive foil layer 204 attached to a bottom surface 171-1 and a top surface 171-2 of the core 103 (e.g., bottom and top surfaces of the core 103 outside of the cavities 113) by a bonding material 206. The conductive foil layer 204 may include any suitable conductive material, such as copper, and may have any suitable thickness (e.g., z-dimension), for example, a thickness of the conductive foil layer may be between 10 microns and 70 microns (e.g., between 15 microns and 35 microns). The bonding material 206 may include any suitable material for physically attaching the conductive foil layer 204 to the core 103, for example, an adhesive material, a mold material, or a dielectric material.

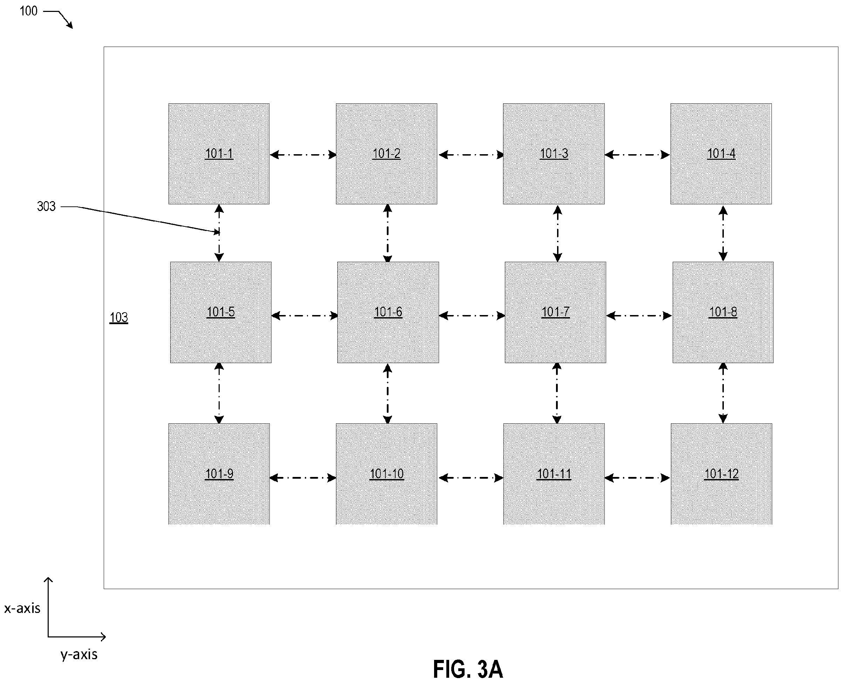

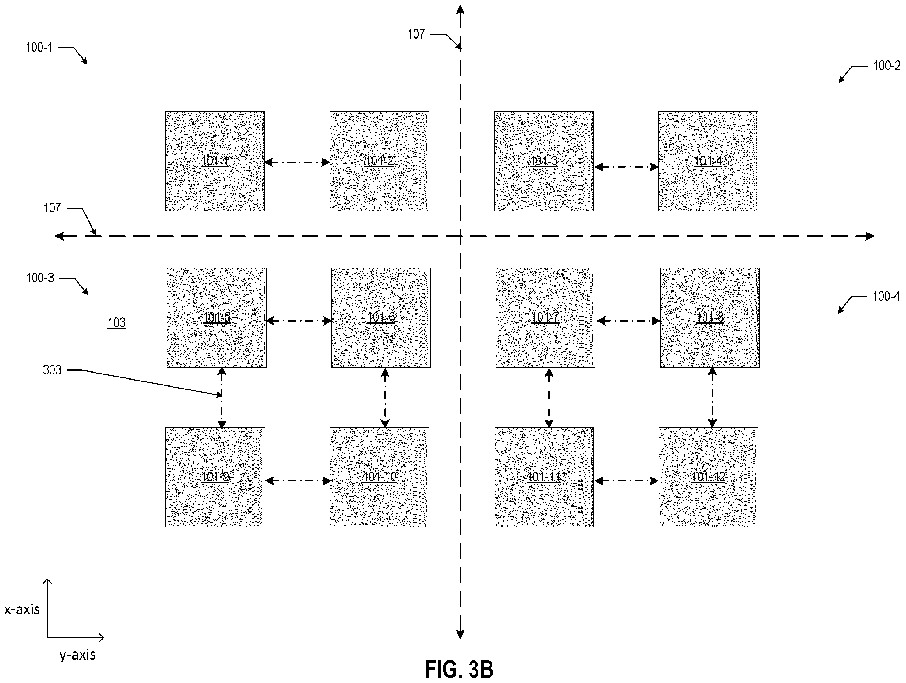

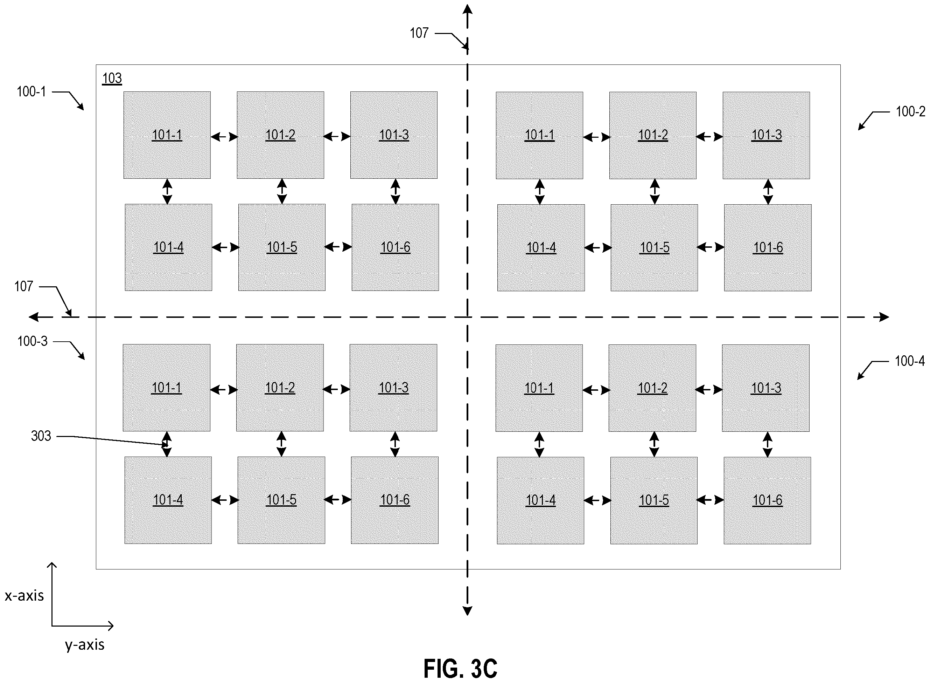

Although FIGS. 1 and 2 show a microelectronic assembly 100 having a particular number and arrangement of subassemblies 101 and of components in the subassemblies 101, a microelectronic assembly 100 may have any suitable number and arrangement of subassemblies 101 and of components in the subassemblies 101. For example, as shown in FIG. 3, a microelectronic assembly 100 may include a plurality of subassemblies 101 that are communicatively coupled.

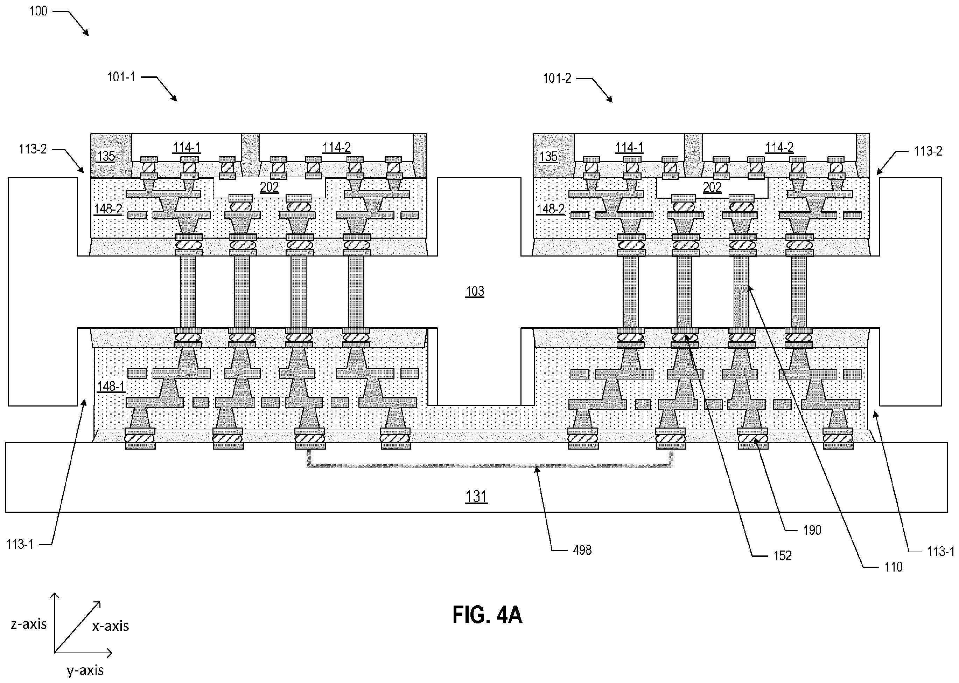

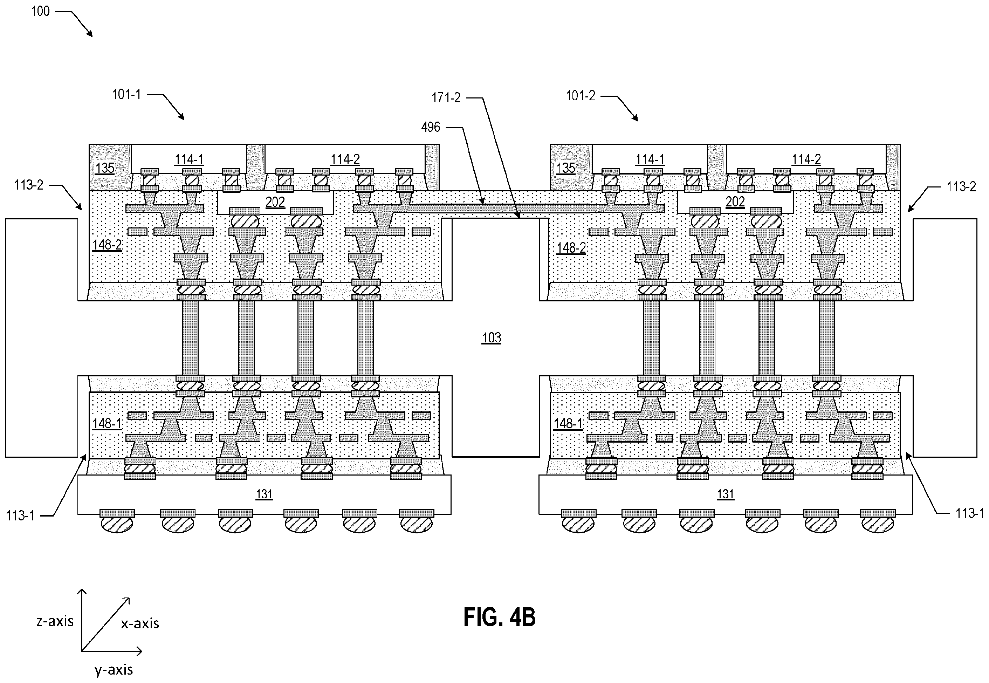

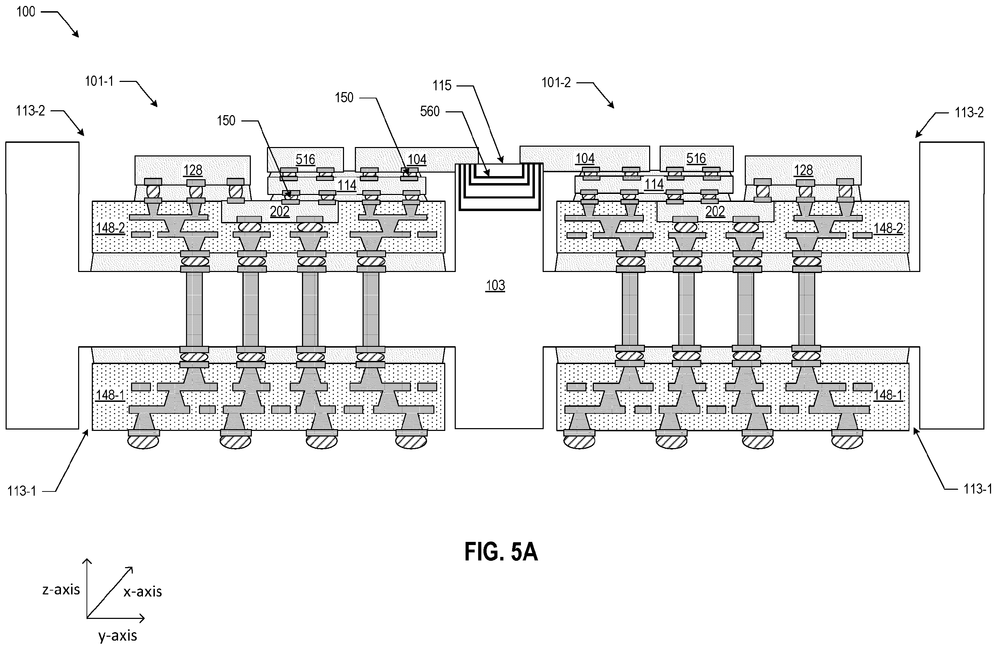

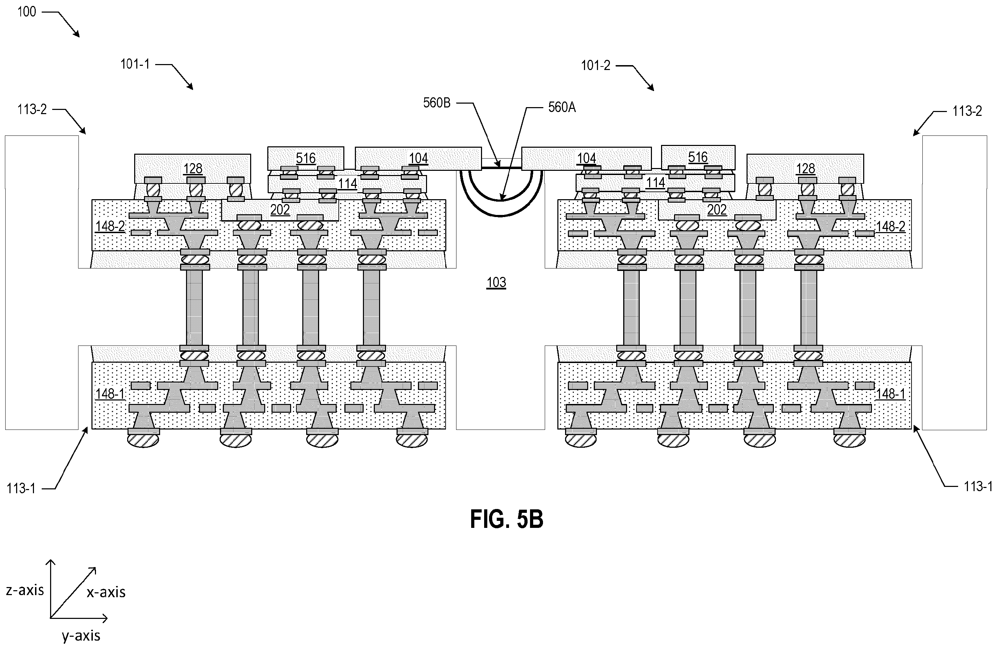

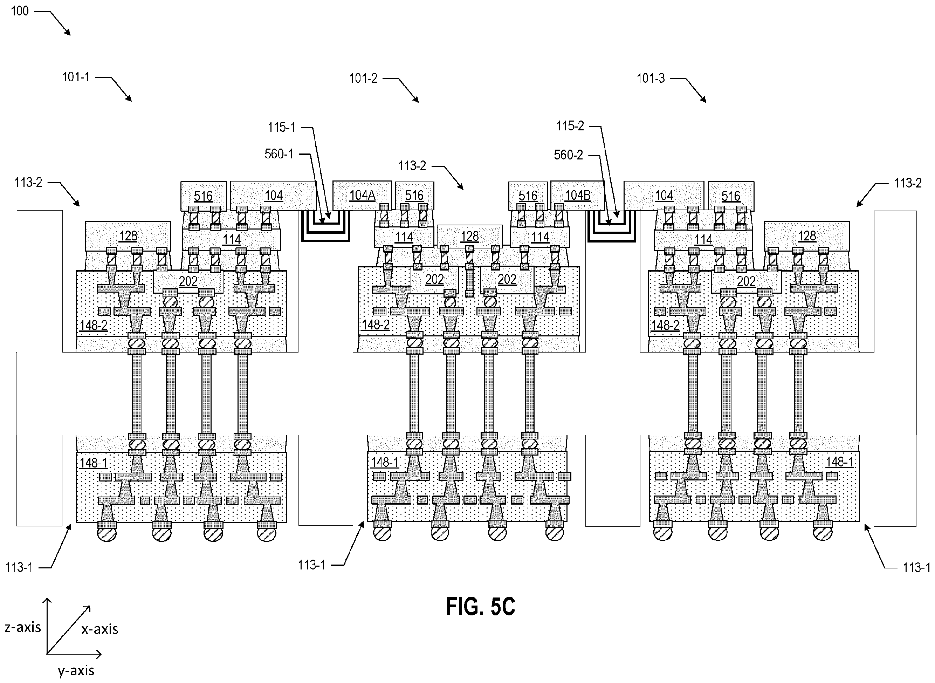

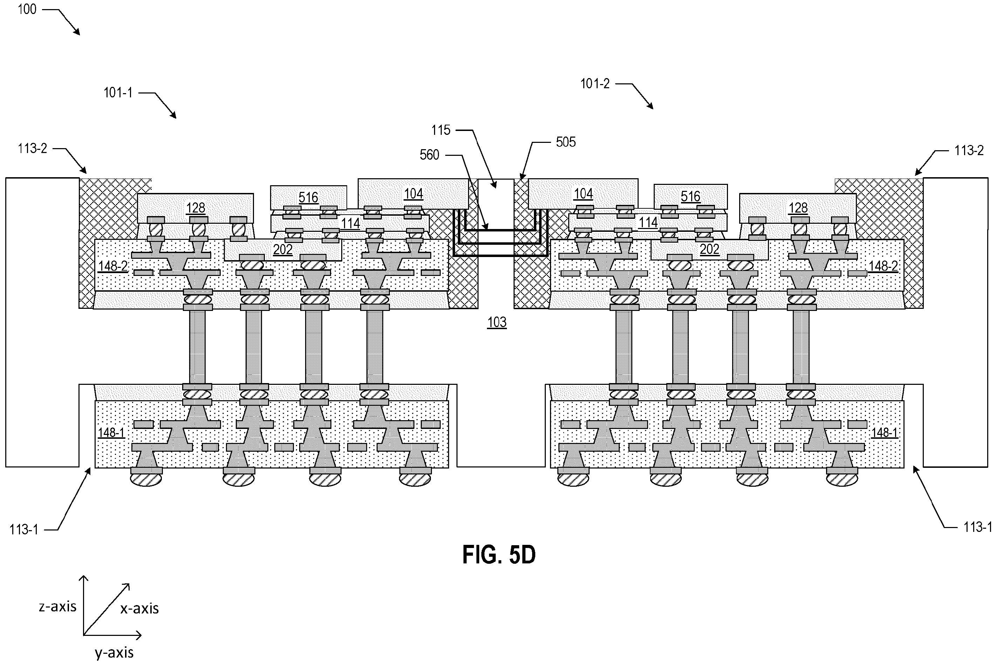

FIG. 3A shows a schematic top view of an example microelectronic assembly according to some embodiments of the present disclosure. The configuration of microelectronic assembly 100 is as described herein except that the microelectronic assembly 100 includes a core 103 having twelve subassemblies 101 (e.g., 101-1 through 101-12) and the subassemblies 101 are communicatively coupled to each other by pathways 303. Although FIG. 3A illustrates communication pathways 303 between adjacent subassemblies 101 (e.g., between subassemblies 101-1 and 101-2 and subassemblies 101-1 and 101-5, and not between subassemblies 101-1 and 101-6), a subassembly 101 may be communicatively coupled to a non-adjacent subassembly 101 by using multiple pathways 303 between adjacent subassemblies 101 (e.g., subassembly 101-1 may be communicatively coupled to subassembly 101-6 through pathways 303 between subassemblies 101-1, 101-5 and subassemblies 101-5, 101-6). In some embodiments, a subassembly 101 may be communicatively coupled to other non-adjacent subassemblies 101 by a pathway that is directly between the non-adjacent subassemblies (e.g., subassembly 101-1 may have a direct communication pathway to subassembly 101-6, for example, by pathways 498 or 496, as described below with reference to FIG. 4). In some embodiments, the subassemblies 101 may be communicatively coupled by electrical pathways (e.g., as shown in FIG. 4). In some embodiments, the subassemblies 101 may be communicatively coupled by optical pathways (e.g., as shown in FIG. 5).

FIG. 3B shows a schematic top view of example microelectronic assemblies according to some embodiments of the present disclosure. The configuration of the embodiments shown in the figure is like that of FIG. 3A, except for differences as described further. FIG. 3B illustrates example microelectronic assemblies 100-1 through 100-4 prior to singulation along saw streets 107. Microelectronic assembly 100-1 includes a core 103 having two subassemblies 101-1, 101-2 communicatively coupled by pathways 303. Microelectronic assembly 100-2 includes a core 103 having two subassemblies 101-3, 101-4 communicatively coupled by pathways 303. Microelectronic assembly 100-3 includes a core 103 having four subassemblies 101-5, 101-6, 101-9, 101-10 communicatively coupled by pathways 303. Microelectronic assembly 100-4 includes a core 103 having four subassemblies 101-7, 101-8, 101-11, 101-12 communicatively coupled by pathways 303. The saw streets 107 are along the thickest portions of the core 103 (e.g., a thickness 191 as shown in FIG. 1), which may add structural rigidity to reduce panel warpage and stress fractures to the core 103 during singulation.

FIG. 3C shows a schematic top view of example microelectronic assemblies according to some embodiments of the present disclosure. The configuration of the embodiments shown in the figure is like that of FIG. 3B, except for differences as described further. FIG. 3C illustrates example microelectronic assemblies 100-1 through 100-4 prior to singulation along saw streets 107, where the singulated microelectronic assemblies 100-1 through 100-4 have a same number and arrangement of subassemblies 101-1 through 101-6. Microelectronic assemblies 100-1 through 100-4 include a core 103 having six subassemblies 101-1 through 101-6 communicatively coupled by pathways 303. The saw streets 107 are along the thickest portions of the core 103 (e.g., a thickness 191 as shown in FIG. 1), which may reduce stress fractures to the core 103 during singulation.

FIG. 4A shows a schematic cross-sectional view of another example microelectronic assembly 100 according to some embodiments of the present disclosure. The configuration of the embodiment shown in the figure is like that of FIG. 2A, except for differences as described further. The configuration of microelectronic assembly 100 is as described herein except that the microelectronic assembly 100 further includes a circuit board 131 electrically coupled by interconnects 190 to the first substrate 148-1 of the subassemblies 101-1, 101-2. The circuit board 131 also includes conductive pathways 498. The respective subassemblies 101-1, 101-2 may be electrically coupled by conductive pathways 498 in the circuit board 131. In some embodiments, the subassemblies 101 may be electrically coupled to an interposer, an organic substrate patch, or another substrate instead of a circuit board.

FIG. 4B shows a schematic cross-sectional view of another example microelectronic assembly 100 according to some embodiments of the present disclosure. The configuration of the embodiment shown in the figure is like that of FIG. 2A, except for differences as described further. The configuration of microelectronic assembly 100 is as described herein except that the microelectronic assembly 100 further includes a respective circuit board 131 electrically coupled by interconnects 190 to the respective first substrates 148-1 of the subassemblies 101-1, 101-2 and the respective second substrates 148-2 of the subassemblies 101-1, 101-2 are electrically coupled by a dielectric material including a conductive pathway 496 on the top surface 171-2 of the core 103. The die 114 in the respective subassemblies 101-1, 101-2 may be electrically coupled by conductive pathway 496. In some embodiments, conductive pathway 496 may electrically couple non-adjacent subassemblies (e.g., subassemblies 101-1 and 101-6 in FIG. 3A). In some embodiments, the dielectric material including the conductive pathway 496 also may be referred to as a redistribution layer (RDL) and may be formed using a redistribution layer (RDL) process (e.g., a semi-additive process). Although FIG. 4B shows the first substrates 148-1 of the subassemblies 101-1, 101-2 electrically coupled to a respective circuit board, the first substrates 148-1 of the subassemblies 101-1, 101-2 may be electrically coupled to a respective interposer or other substrate instead of a circuit board.

FIG. 5A shows a schematic cross-sectional view of another example microelectronic assembly 100 according to some embodiments of the present disclosure. The configuration of the embodiment shown in the figure is like that of FIG. 2A, except for differences as described further. The configuration of microelectronic assembly 100 is as described herein except that the microelectronic assembly 100 further includes photonic components for transmitting and receiving optical signals. As shown in FIG. 5A, a microelectronic assembly 100 may include a subassembly 101 further including a photonic integrated circuit (PIC) 104, a logic integrated circuit (XPU) 128, and a microprocessor die 516. The die 114 may function as an electrical integrated circuit (EIC) and may be electrically coupled to the bridge die 202, the microprocessor die 516, and PIC 104 by interconnects 150. PIC 104 of subassembly 101-1 may transmit and receive optical signals from PIC 104 of subassembly 101-2 by optical pathways 560 through a glass portion 115 of the core 103 between the respective subassemblies 101-1, 101-2. As used herein, the term "optical pathway" refers to a path or trajectory by which light propagates from one location to another location through an optical medium. In some embodiments, an optical pathway 560 may include one or more waveguides or other structures that guide the path of light. In some embodiments, the optical pathway 560 may include a reflector or other component configured to transmit a signal from a vertical direction to a lateral direction or from a lateral direction to a vertical direction. In some embodiments, an optical pathway 560 may be formed subsequent to attachment of PIC 104 (e.g., in situ laser written waveguide, as described above). A microelectronic assembly 100 including photonic components may be referred to herein as a "photonic package" or a "photonic assembly" and a die 114 including EIC circuitry may be referred herein as EIC die 114.

PIC 104 may include optical elements for transmitting and/or receiving an optical signal and conductive contacts on a bottom surface of PIC 104 may be electrically and mechanically coupled to the conductive contacts on the top surface of the EIC die 114 by interconnects 150. Optical elements may be optically coupled to optical pathways 560 through a glass portion 115 of the core 103 between the subassemblies 101-1, 101-2. Example optical elements included in PIC 104 include an electromagnetic radiation source, an electro-optical device, and a waveguide. In many embodiments, the optical elements may be fabricated on a surface of PIC 104 using any known method in the art, including semiconductor photolithographic and deposition methods. PIC 104 may be configured to transmit and/or receive an optical signal at a bottom surface, as shown in FIG. 5A. For example, PIC 104 may include optical elements, such as a grating coupler, at a bottom surface that allow PIC 104 to transmit and/or receive light through the bottom surface (e.g., vertical transmission and reception of light). In some embodiments, as shown in FIG. 5A, PIC 104 may have a bottom surface with tiered profile for physically coupling to the glass portion 115 and transmitting light at the bottom surface. In other embodiments, as shown in FIG. 5C, PIC 104 may have a planar bottom surface for physically coupling to the glass portion 115 and transmitting light at the bottom surface. In some embodiments, a PIC 104 may be configured to transmit and/or receive an optical signal at a lateral surface and/or at a bottom surface, as shown in FIG. 5B. In such examples, PIC 104 may include optical elements, such as an edge coupler, a v-groove array, or an angled reflector with a grating coupler, that allow PIC 104 to transmit and/or receive light through a lateral surface that is substantially perpendicular to the bottom surface (e.g., lateral transmission and reception of light). PIC 104 may be physically coupled to the glass portion 115 of the core 103 using any suitable attachment means, for example, optical glue or fusion bonding. Optical glue may include any suitable material that permits optical signals to pass through while serving to adhere PIC 104 and glass portion 115 of the core 103. The materials may include, by way of examples, and not as limitations, ultraviolet curing optical adhesives, epoxies, silicone, modified silane, and acrylates. Fusion bonding may include a layer of bonding material, such as alumina, optical epoxy, or silicon oxide, on a bonding surface. In some embodiments, the bonding material may cover optical elements on the surface of PIC 104 and may function as a protective layer that maintains integrity of the optical elements during fabrication processes to which PIC 104 may be subjected, for example, attaching, solder reflowing, grinding, polishing, underfilling, and molding. The layer of bonding material may ensure, for example, that optical transmission properties of the optical elements are not compromised during the fabrication processes by contamination with mold or underfill material, or that optical functionality is not compromised by tearing, breaking, or other destructive events during the fabrication processes. The layer of bonding material may also serve to avoid leaking optical signals from the optical elements during operation of PIC 104. For example, the bonding material may further serve to provide oxide-to-oxide bonding between the optical elements of PIC 104 and the glass portion 115 of the core 103 when a silicon oxide material is used. In another example, the bonding material may serve to provide nitride-to-nitride bonding between the optical elements of PIC 104 and the glass portion 115 of the core 103 when a silicon nitride material is used. The silicon oxide layers in oxide-to-oxide bonding, or the silicon nitride layers in nitride-to-nitride bonding, may be bonded initially by Van-der-Waals forces and subsequently by high temperature fusion bonding. The oxide-to-oxide bonding and nitride-to-nitride bonding may decrease optical signal losses.

EIC die 114 may be configured to electrically integrate with PIC 104, the microprocessor die 516, and XPU 128 through bridge die 202 to achieve an intended functionality of microelectronic assembly 100. For example, an EIC die 114 may be an Application Specific IC (ASIC), including one or more switch or driver/receiver circuits used in optical communication systems. In some embodiments, EIC die 114 may include circuitry for communicating between two or more IC dies, for example, between XPU 128, the microprocessor die 516, and PIC 104. In some embodiments, EIC die 114 may comprise active components, including one or more transistors, voltage converters, trans-impedance amplifiers (TIA), serializer and de-serializer (SERDES), clock and data recovery (CDR) components, microcontrollers, etc. In some embodiments, EIC die 114 may comprise passive circuitry sufficient to enable interconnection to PIC 104 and other components in microelectronic assembly 100 without any active components.

XPU 128 may include any suitable IC functionality. In some embodiments, XPU 128 may include a processor integrated circuit (XPU) having processing functionality, such as Central Processing Unit (CPU), Graphics Processing Unit (GPU), Field-Programmable Gate Array (FPGA), ASIC, and accelerator. In various embodiments, XPU may be, or include, one or more voltage converters, Trans Impedance Amplifier (TIA), Clock and Data Recovery (CDR) components, microcontrollers, etc. Although FIG. 5A shows XPU 128, EIC die 114, and the microprocessor die 516 as separate ICs, in some embodiments, a single IC may include XPU, microprocessor, and/or EIC functionality such that one or more of XPU 128, EIC die 114, and the microprocessor die 516 may be omitted from a microelectronic assembly 100. In some embodiments, a microelectronic assembly 100 may include multiple XPUs 128, multiple EIC die 114, and multiple microprocessor die 516. In some embodiments, EIC die 114 may function as an interconnect die and the bridge die 202 may be omitted from a microelectronic assembly 100.

FIG. 5B shows a schematic cross-sectional view of another example microelectronic assembly 100 according to some embodiments of the present disclosure. The configuration of the embodiment shown in the figure is like that of FIG. 5A, except for differences as described further. The configuration of microelectronic assembly 100 is as described herein except that the microelectronic assembly 100 also includes a glass portion 115 with a cutout for physically coupling PIC 104 having a planar bottom surface and PIC 104 are further configured to transmit and/or receive an optical signal at a lateral surface and at the bottom surface. The microelectronic assembly 100 further shows optical pathways 560 having different profiles, where optical pathway 560A has a curved profile and optical pathway 560B has a linear profile. Although FIGS. 5A and 5B show a microelectronic assembly 100 having a particular number of optical pathways with a particular profile, a microelectronic assembly 100 may have any suitable number of optical pathways with any suitable profile, including, for example, linear, multiple linear lines, curved, parabolic, sloped, U-shaped, etc., and combinations thereof.

FIG. 5C shows a schematic cross-sectional view of another example microelectronic assembly 100 according to some embodiments of the present disclosure. The configuration of the embodiment shown in the figure is like that of FIG. 5A, except for differences as described further. The configuration of microelectronic assembly 100 is as described herein except that the microelectronic assembly 100 also includes three subassemblies 101-1, 101-2, 101-3, where subassembly 101-2 includes multiple PIC 104A, 104B, multiple EIC die 114, multiple microprocessor die 516, and multiple bridge die 202. In particular, PIC 104 of subassembly 101-1 is optically coupled to PIC 104A of subassembly 101-2 by optical pathways 560-1 through a glass portion 115-1 of a core 103 and PIC 104B of subassembly 101-2 is optically coupled to PIC 104 of subassembly 101-3 by optical pathways 560-2 through a glass portion 115-2 of the core 103. Although FIG. 5C shows a particular number and arrangement of photonic components in subassemblies 101, a microelectronic assembly 100 may have any suitable number and arrangement of photonic components in subassemblies 101 and the number and arrangement of photonic components may depend on the number of subassemblies 101 and the number of optical pathways 560 between subassemblies 101 in the microelectronic assembly 100.

FIG. 5D shows a schematic cross-sectional view of another example microelectronic assembly 100 according to some embodiments of the present disclosure. The configuration of the embodiment shown in the figure is like that of FIG. 5C, except for differences as described further. The configuration of microelectronic assembly 100 is as described herein except that the microelectronic assembly 100 also includes an optical polymer 505 in a cavity 113-2 and around the subassembly 101, where an optical pathway 560 extends through the optical polymer 505 around the subassembly 101-1, through a glass portion 115 between the subassemblies 101-1, 101-2, and through the optical polymer 505 around the subassembly 101-2. The optical polymer may include any suitable optical polymer, for example, siloxane and acrylate. In some embodiments, the optical polymer 505 may provide mechanical stability to the microelectronic assembly 100. Although FIGS. 5A-5D show substrates 148 electrically coupled to TGVs 110 by interconnects 152, substrates 148 may be electrically coupled to TGVs 110 by any suitable interconnects, including any interconnects disclosed herein, for example, interconnects 154 in FIG. 2B and interconnects 156 in FIG. 2C.

Any suitable techniques may be used to manufacture the microelectronic assemblies 100 disclosed herein. For example, FIGS. 6A-6D are side, cross-sectional views of various stages in an example process for manufacturing a microelectronic assembly 100 similar to FIG. 2A, in accordance with various embodiments. Although the operations discussed below with reference to FIGS. 6A-6D (and others of the accompanying drawings representing manufacturing processes) are illustrated in a particular order, these operations may be performed in any suitable order. Further, additional operations which are not illustrated may also be performed without departing from the scope of the present disclosure. Also, various ones of the operations discussed herein with respect to FIGS. 6A-6D may be modified in accordance with the present disclosure to fabricate others of microelectronic assembly 100 disclosed herein.

FIG. 6A illustrates an assembly including a core 103 having a bottom surface 171-1 and a top surface 171-2. The core 103 may have any suitable dimensions, for example, the core 103 may include a full panel glass core having a surface area of approximately 500 millimeters by 500 millimeters (e.g., xy-dimension), or may include a quarter panel glass core having a surface area of approximately 250 millimeters by 250 millimeters. The core 103 may have a thickness (e.g., z-dimension) between 50 microns and 2 millimeters.

FIG. 6B illustrates an assembly subsequent to forming cavities 613 and via openings 611 in the core 103. The cavities 613 may include first cavities 613-1 formed in the bottom surface 171-1 of the core 103 and second cavities 613-2 formed in the top surface 171-2 of the core 103. The first cavities 613-1 include a top surface 170-1 and the second cavities 613-2 include a bottom surface 170-2. The cavities 613 and via openings 611 may be formed using any suitable process, including lithography, laser assisted wet etch, laser drilling (e.g., laser ablation using excimer laser), or plasma etching. The cavities 613 and via openings 611 may have any suitable shape. For example, the cavities 613 may have substantially vertical sidewalls, or may have angled sidewalls that narrow towards a bottom of the cavities 613, and the via openings 611 may have substantially vertical sidewalls to form rectangular-shaped vias, may have angled sidewalls to form conical-shaped vias, or may have double angled sidewalls to form hourglass-shaped vias. The shape of cavities 613 and the via openings 611 may depend on the process used to form cavities 613 and the via openings 611 (e.g., a lithographic process for vertical sidewalls and a laser drilling process for angled sidewalls).

FIG. 6C illustrates an assembly subsequent to plating a conductive material in the via openings 611 of FIG. 6B to form TGVs 110 and plating conductive pads 174, 172 at the first surface 170-1 and second surface 170-2 of the core 103, respectively. TGVs 110 may include any suitable conductive material, such as copper, silver, nickel, gold, aluminum, or other metals or alloys, and may be deposited using any suitable process, including lithography, electrolytic plating, or electroless plating.

FIG. 6D illustrates an assembly subsequent to forming interconnects 152, forming substrates 148-1, 148-2 on respective first and second surfaces 170-1, 170-2 of the core 103, embedding bridge die 202 in the second substrate 148-2, attaching dies 114-1, 114-2 to a top surface of the second substrate 148-2 by forming interconnects 150, and depositing an underfill material 127. The assembly of FIG. 6D may be manufactured using conventional package substrate manufacturing techniques. The dielectric of the substrate 148 may be deposited using any suitable technique, including lamination, and may be removed using any suitable technique, such as laser patterning or lithography, to form a cavity for placing a bridge die 202 therein. In some embodiments, bridge die 202 may be omitted. The conductive pathways 196 may be any suitable conductive material, such as copper, silver, nickel, gold, aluminum, or other metals or alloys, and may be deposited using any suitable process, including lithography, electrolytic plating, or electroless plating. In some embodiments, the substrate 148-1 and the substrate 148-2 including a bridge die 202 and die 114 may be manufactured separately as subassemblies, then placed in respective cavities 613-1, 613-2 and attached to the core 103 by forming interconnects 152. The assembly of FIG. 6D may itself be a microelectronic assembly 100, as shown. Further manufacturing operations may be performed on the microelectronic assembly 100 of FIG. 6D to form other microelectronic assemblies 100; for example, singulating through the glass portions 115 (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching a circuit board 131 to a bottom surface of the microelectronic assembly 100 of FIG. 6D by forming interconnects 190, similar to FIGS. 1 and 4A.

FIGS. 7A-7D are side, cross-sectional views of various stages in an example process for manufacturing a microelectronic assembly 100 similar to FIG. 2B, in accordance with various embodiments. FIG. 7A illustrates an assembly including a core 103 having a first surface 170-1, an opposing second surface 170-2, TGVs 110, and conductive pads 174, 172 at the first surface 170-1 and second surface 170-2 of the core 103, respectively. In some embodiments, the conductive pads 174, 172 may be omitted. The core 103 may have any suitable dimensions, for example, the core 103 may include a full panel glass core having a surface area of approximately 500 millimeters by 500 millimeters (e.g., xy-dimension), or may include a quarter panel glass core having a surface area of approximately 250 millimeters by 250 millimeters. The core 103 may have a thickness (e.g., z-dimension) between 50 microns and 2 millimeters.

FIG. 7B illustrates an assembly subsequent to placing glass portions 715-1, 715-2 on the first surface 170-1 and second surface 170-2 of the core 103, respectively. The glass portions 715-1, 715-2 may have any suitable dimensions for forming respective cavities 713-1, 713-2. In some embodiments, glass portions 715 may have a thickness (z-dimension) between 50 microns and 2 millimeters.

FIG. 7C illustrates an assembly subsequent to mechanically coupling glass portions 715-1, 715-2 to the respective first and second surfaces 170-1, 170-2 of the core 103 to form cavities 713-1, 713-2. Glass portions 715 may be attached to the core 103 by oxide-oxide bonds 106 (e.g., 106-1, 106-2, respectively), where a glass material of the glass portions 715 and a glass material of the core 103 bond with each other. In some embodiments, subsequent to bonding, the individual glass portions 715 may be undetectable (e.g., have a seamless interface) such that the core 103 appears to be a single component. In some embodiments, subsequent to bonding, an interface seam may exist at the interface between the individual glass portions 715 and the core 103.

FIG. 7D illustrates an assembly subsequent to forming substrates 148-1, 148-2 on respective first and second surfaces 170-1, 170-2 of the core 103, forming interconnects 154, embedding bridge die 202 in the second substrate 148-2, attaching dies 114-1, 114-2 to a top surface of the second substrate 148-2 by forming interconnects 150, and depositing an underfill material 127. The assembly of FIG. 7D may be manufactured using any suitable technique, including, for example, conventional package substrate manufacturing techniques, as described above with reference to FIG. 6D. The assembly of FIG. 7D may itself be a microelectronic assembly 100, as shown. Further manufacturing operations may be performed on the microelectronic assembly 100 of FIG. 7D to form other microelectronic assemblies 100; for example, singulating through the glass portions 115 (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching a circuit board 131 to a bottom surface of the microelectronic assembly 100 of FIG. 7D by forming interconnects 190, similar to FIG. 1.

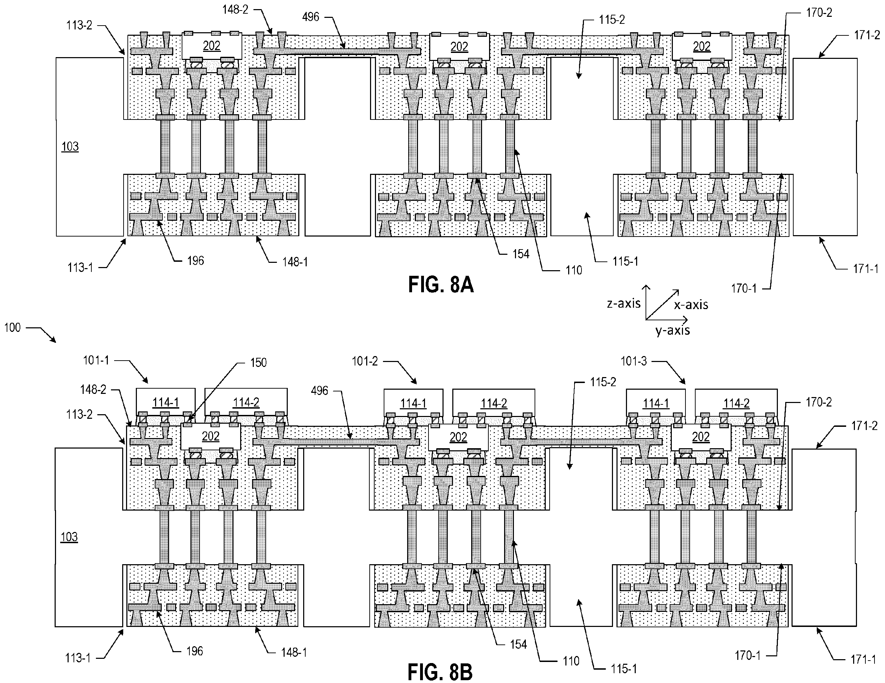

FIGS. 8A and 8B are side, cross-sectional views of various stages in an example process for manufacturing a microelectronic assembly 100 similar to FIG. 4B, in accordance with various embodiments. FIG. 8A illustrates an assembly subsequent to forming cavities 113-1, 113-2 in a core 103 having TGVs 110, forming substrates 148-1, 148-2 on respective first and second surfaces 170-1, 170-2 of the core 103, forming interconnects 154, embedding bridge die 202 in the second substrate 148-2, and forming a conductive pathway 496 through a dielectric material on a top surface 171-2 of a glass portion 115 of the core 103. The assembly of FIG. 8A may be manufactured using any suitable technique, including, for example, the manufacturing techniques, as described above with reference to FIG. 6 and/or FIG. 7. The conductive pathway 496 through a dielectric material may be formed using conventional package substrate techniques or a redistribution layer (RDL) process (e.g., a semi-additive process).

FIG. 8B illustrates an assembly subsequent to attaching dies 114-1, 114-2 to a top surface of the second substrate 148-2 by forming interconnects 150, and depositing an underfill material 127. The respective die 114-1, 114-2 in the subassemblies 101-1, 101-2, 101-3 may be electrically coupled by conductive pathway 496, as shown. The assembly of FIG. 8B may itself be a microelectronic assembly 100, as shown. Further manufacturing operations may be performed on the microelectronic assembly 100 of FIG. 8B to form other microelectronic assemblies 100; for example, singulating through the glass portions 115 (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching one or more circuit boards 131 to a bottom surface of the microelectronic assembly 100 of FIG. 8B by forming interconnects 190, similar to FIGS. 4A or 4B.

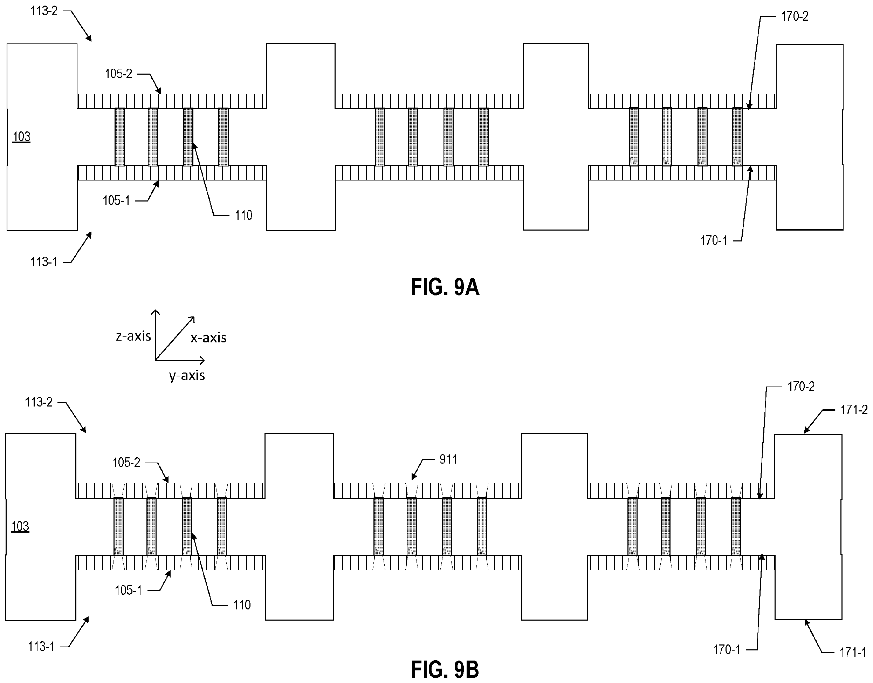

FIGS. 9A-9D are side, cross-sectional views of various stages in an example process for manufacturing the microelectronic assembly 100 of FIG. 2C, in accordance with various embodiments. FIG. 9A illustrates an assembly including a core 103 with cavities 113-1, 113-2, TGVs 110 extending through the core 103 between first and second surfaces 170-1, 170-2, and a buffer material 105-1, 105-2 on the respective first and second surfaces 170-1, 170-2 of the core 103. The assembly may be manufactured using any suitable technique, for example, as described above with reference to FIG. 6 and/or FIG. 7. The buffer material 105 may be deposited using any suitable technique, including lamination, spin coating, spray coating, and slit coating. The buffer material 105 may include any suitable material and have any suitable dimensions, as described above with reference to FIG. 2C.

FIG. 9B illustrates an assembly subsequent to forming via openings 911 in the buffer material 105-1, 105-2 at the first and second surfaces 170-1, 170-2 of the core 103. The via openings 911 may be formed using any suitable process, including lithography or laser drilling. The via openings 911 may have any suitable shape. For example, the via openings 911 may have angled sidewalls to form conical-shaped vias or may have substantially vertical sidewalls to form rectangular-shaped openings. The shape of the via openings 911 may depend on the process used to form them (e.g., a lithographic process for rectangular-shaped vias and a laser drilling process for conical-shaped vias).

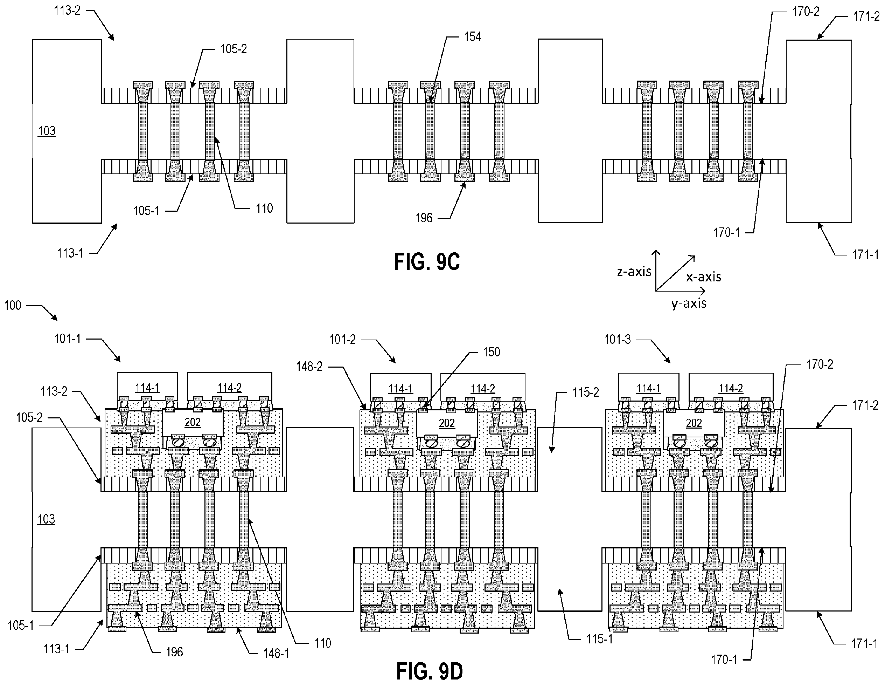

FIG. 9C illustrates an assembly subsequent to depositing a conductive material in the via openings 913 to form conductive pathways 196 and interconnects 154. The conductive pathways 196 may include any suitable conductive material, such as copper, and may be deposited using any suitable process, including lithography, electrolytic plating, or electroless plating.

FIG. 9D illustrates an assembly subsequent to forming substrates 148-1, 148-2 on buffer material 105-1, 105-2 at respective first and second surfaces 170-1, 170-2 of the core 103, embedding bridge die 202 in the second substrate 148-2, attaching dies 114-1, 114-2 to a top surface of the second substrate 148-2 by forming interconnects 150, and depositing an underfill material 127. The assembly of FIG. 9D may be manufactured using any suitable technique, including, for example, conventional package substrate manufacturing techniques, as described above with reference to FIGS. 6 and/or 7. The assembly of FIG. 9D may itself be a microelectronic assembly 100, as shown. Further manufacturing operations may be performed on the microelectronic assembly 100 of FIG. 9D to form other microelectronic assemblies 100; for example, singulating through the glass portions 115 (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching a circuit board 131 to a bottom surface of the microelectronic assembly 100 of FIG. 9D by forming interconnects 190, similar to FIG. 1.

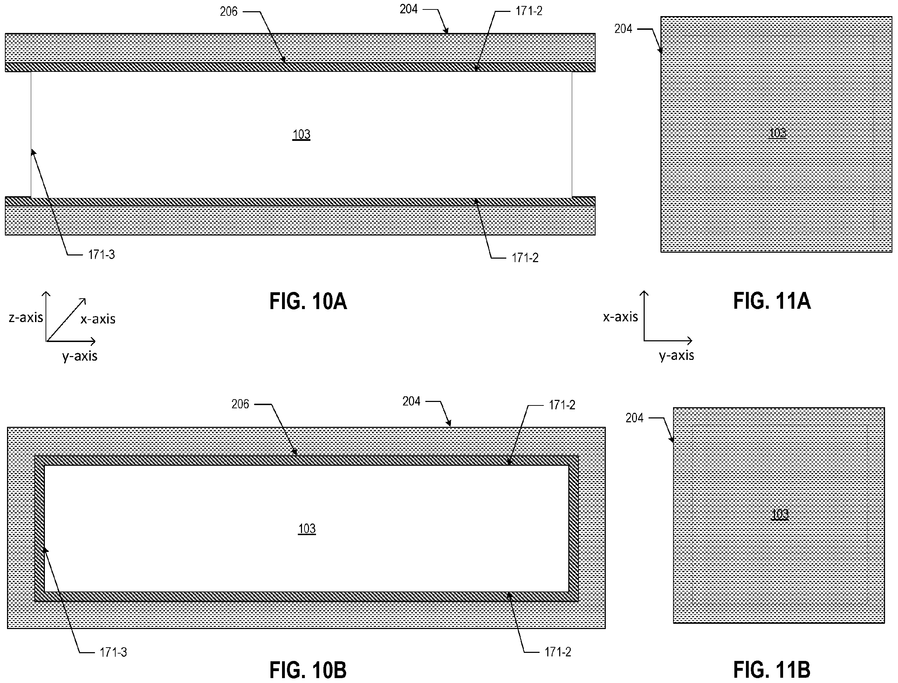

FIGS. 10A-10H are side, cross-sectional views and FIG. 11A-11H are top views of various stages in an example process for manufacturing the microelectronic assembly 100 of FIGS. 2D and 2E, in accordance with various embodiments. FIG. 10A illustrates an assembly including a core 103 having a conductive foil layer 204 attached to a bottom surface 171-1 and a top surface 171-2 of the core 103 by a bonding material 206. The conductive foil layer 204 and the bonding material 206 extend beyond a footprint of the core 103. FIG. 11A illustrates the conductive foil layer 204 on a top surface of the core 103 and extending beyond a footprint of the core 103 (e.g., xy-dimension indicated by dashed lines). The core 103 may have any suitable dimensions, including a thickness (e.g., z-dimension) between 50 microns and 2 millimeters.

FIG. 10B illustrates an assembly subsequent to bending the extended portions of the conductive foil layer 204 with the bonding material 206 and attaching to lateral surfaces 171-3 of the core 103. The conductive foil layer 204 may fully encapsulate the core 103 and may function to protect the core 103, particularly, the lateral surfaces 171-3. The assembly of FIG. 10B may be formed by compressing the assembly using any suitable technique, for example, a rubber press. FIG. 11B illustrates the conductive foil layer 204 on the top surface of the core 103, where the surface area (e.g., xy-dimension) of the conductive foil layer 204 is reduced due to bending and attaching to the lateral surfaces 171-3.

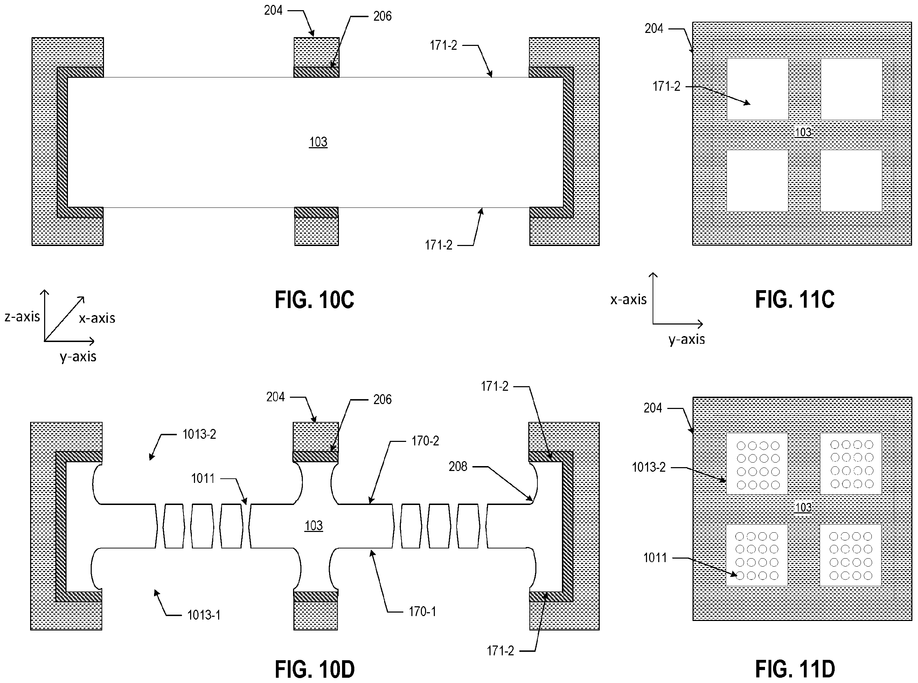

FIG. 10C illustrates an assembly subsequent to removing portions of the conductive foil layer 204 and bonding material 206 and forming openings in the conductive foil layer 204 that expose the bottom and top surfaces 171-1, 171-2 of the core 103. The conductive foil layer 204 may be cut out and removed using any suitable technique, including by using a conventional router or laser ablation. The bonding material 206 may be removed using any suitable technique, including a desmear or a plasma etch process. FIG. 11C illustrates the conductive foil layer 204 on the top surface of the core 103 with portions removed to expose the top surface 171-2 of the core 103. The remaining portions of the conductive foil layer 204 may form a picture frame, and the removed portions are where cavities will be formed, as described below with reference to FIG. 10D.

FIG. 10D illustrates an assembly subsequent to forming cavities 1013 and via openings 1011 in the core 103. The cavities 1013 may include first cavities 1013-1 formed in the bottom surface 171-1 of the core 103 and second cavities 1013-2 formed in the top surface 171-2 of the core 103. The first cavities 1013-1 include a top surface 170-1 and the second cavities 1013-2 include a bottom surface 170-2. The cavities 1013 may be formed using any suitable process, including laser assisted wet etch. The cavities 1013 may have any suitable shape, and may further include an undercut 208 along sidewalls of the first and second cavities 1013-1, 1013-2 at respective first and second surfaces 170-1, 170-2 of the core 103 (e.g., as described above with reference to FIG. 2D and 2E). The cavities 1013 may have any suitable dimensions, for example, the cavities 1013 may have a depth (e.g., z-dimension) between 5 microns and 25 microns, which may depend on the amount of exposure during a laser assisted wet etch process, where approximate 10% of the glass thickness may be removed. In some embodiments, the cavities 1013 may have a greater depth (e.g., between 10 microns and 50 microns). The via openings 1011 may have any suitable shape. For example, the via openings 1011 may have double angled sidewalls to form hourglass-shaped vias, as shown, may have angled sidewalls to form conical-shaped vias, or may have substantially vertical sidewalls to form rectangular-shaped vias. The via openings 1011 may be formed using any suitable process, for example, as described above with reference to FIG. 6B. FIG. 11D illustrates the conductive foil layer 204 on the top surface of the core 103 with portions removed exposing the cavities 1013-2 and the via openings 1011 formed in the top surface 171-2 of the core 103.

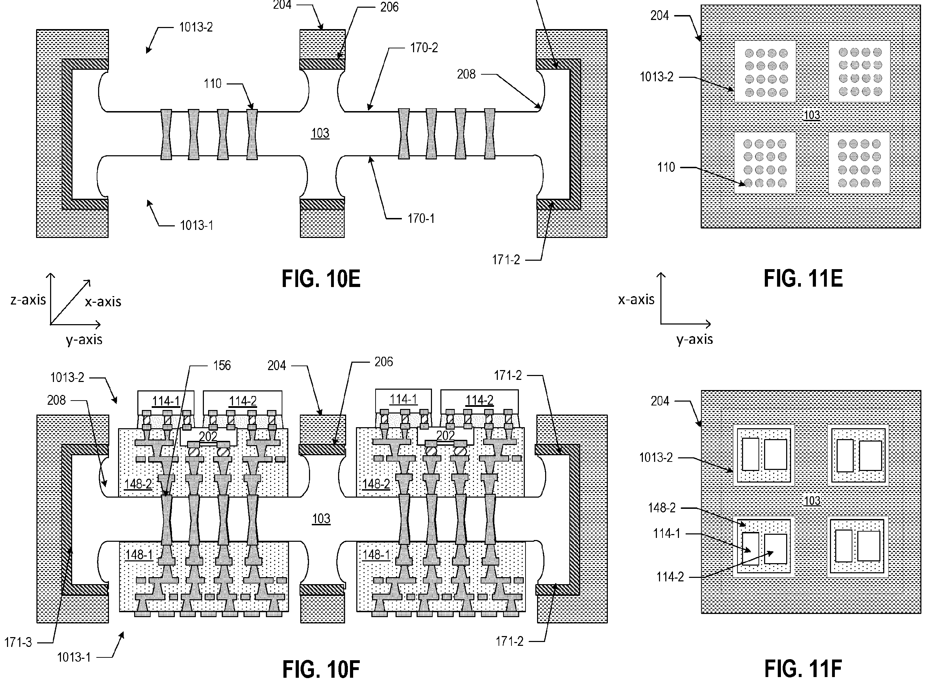

FIG. 10E illustrates an assembly subsequent to plating a conductive material in the via openings 1011 to form TGVs 110. TGVs 110 may include any suitable conductive material, such as copper, silver, nickel, gold, aluminum, or other metals or alloys, and may be deposited using any suitable process, including lithography, electrolytic plating, or electroless plating. FIG. 11E illustrates a top view of the TGVs 110 subsequent to plating a conductive material in the via openings 1011.

FIG. 10F illustrates an assembly subsequent to forming substrates 148-1, 148-2 on respective first and second surfaces 170-1, 170-2 of the core 103, embedding bridge die 202 in the second substrate 148-2, attaching dies 114-1, 114-2 to a top surface of the second substrate 148-2 by forming interconnects 150, and depositing an underfill material 127. The assembly of FIG. 10F may be manufactured using conventional package substrate manufacturing techniques, as described above with reference to FIG. 6D. FIG. 11F illustrates the conductive foil layer 204 on the top surface of the core 103 with portions removed exposing the substrates 148-2 with attached dies 114-1, 114-2 in the cavities 1013-2.

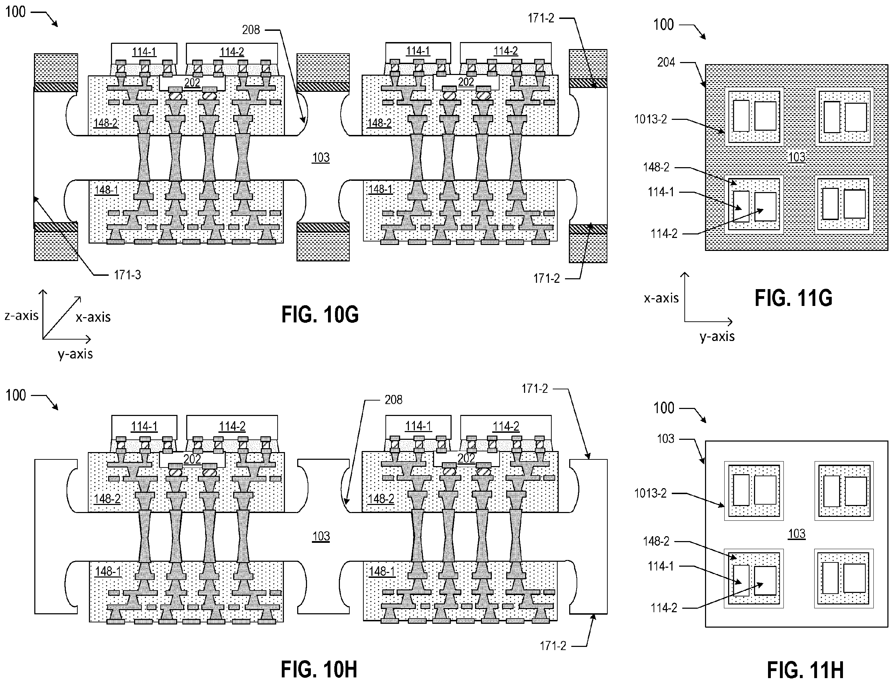

FIG. 10G illustrates an assembly subsequent to removing the conductive foil layer 204 and the bonding material 206 from the lateral surfaces 171-3 of the core 103. The conductive foil layer 204 and the bonding material 206 may be removed using any suitable technique, for example, a selective metal etching process and a plasma etching process. FIG. 11G illustrates the conductive foil layer 204 on the top surface of the core 103 with portions removed from the lateral surfaces 171-3 (e.g., the surface area (i.e., xy-dimension) of the assembly is reduced due to removing the conductive foil layer 204 and the bonding material 206 from the lateral surfaces 171-3). The assembly of FIGS. 10G and 11G may itself be a microelectronic assembly 100, as shown. Further manufacturing operations may be performed on the microelectronic assembly 100 of FIGS. 10G and 11G to form other microelectronic assemblies 100 similar to FIG. 2E; for example, singulating (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching a circuit board 131 to a bottom surface of the microelectronic assembly 100 of FIGS. 10G and 11G by forming interconnects 190, similar to FIG. 1.

FIG. 10H illustrates an assembly subsequent to removing the conductive foil layer 204 and the bonding material 206 from the bottom and top surfaces 171-1, 171-2 of the core 103. The conductive foil layer 204 and the bonding material 206 may be removed using any suitable technique, for example, a selective metal etching process and a plasma etching process. FIG. 11H illustrates the top surface 171-2 of the core 103 after the conductive foil layer 204 and the bonding material 206 have been removed from the bottom and top surfaces 171-1, 171-2 of the core 103. The assembly of FIGS. 10H and 11H may itself be a microelectronic assembly 100, as shown. Further manufacturing operations may be performed on the microelectronic assembly 100 of FIGS. 10H and 11H to form other microelectronic assemblies 100 similar to FIG. 2D; for example, singulating (e.g., at the portions of the core 103 having a thickness 191, as shown in FIG. 1), depositing an insulating material 135 on and around the dies 114-1, 114-2, performing surface finishing operations, such as depositing solder resist, depositing solder 136 at a bottom surface of the first substrate 148-1, attaching a circuit board 131 to a bottom surface of the microelectronic assembly 100 of FIGS. 10H and 11H by forming interconnects 190, similar to FIG. 1.

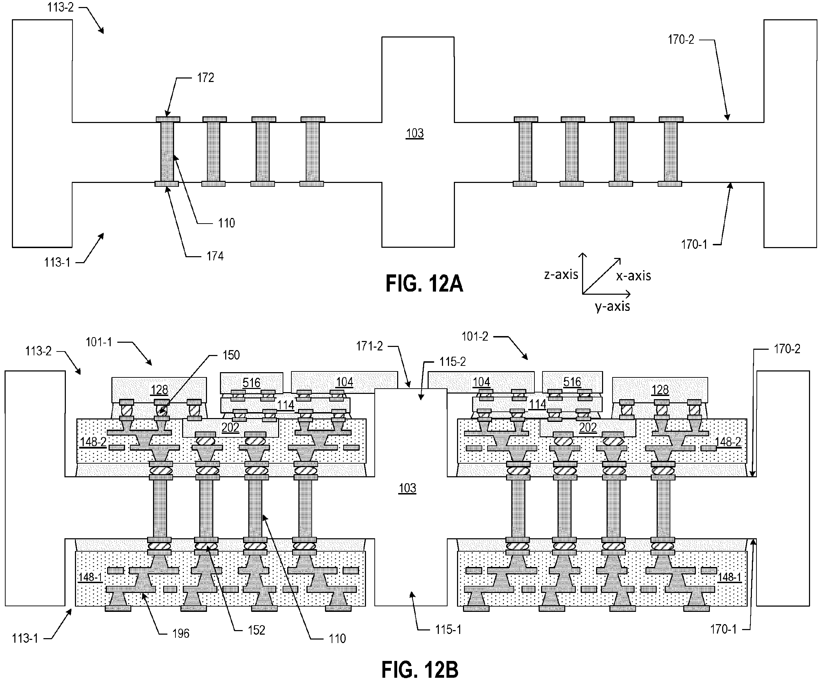

FIGS. 12A-12C are side, cross-sectional views of various stages in an example process for manufacturing the microelectronic assembly 100 of FIG. 5A, in accordance with various embodiments. FIG. 12A illustrates an assembly including a core 103 with cavities 113-1, 113-2, and TGVs 110 extending through the core 103 between first and second surfaces 170-1, 170-2 of the core 103. The assembly of FIG. 12A may be manufactured using any suitable technique, for example, as described above with reference to FIG. 6 and/or FIG. 7.

FIG. 12B illustrates an assembly subsequent to forming substrates 148-1, 148-2 on respective first and second surfaces 170-1, 170-2 of the core 103, forming interconnects 152, embedding bridge die 202 in the second substrate 148-2, attaching EIC die 114 and XPU 128 to a top surface of the second substrate 148-2 by forming interconnects 150, and attaching microprocessor die 516 and PIC 104 to a top surface of EIC die 114 by forming interconnects 150. PIC 104 may have a tiered bottom surface and may be optically coupled to a planar top surface 171-2 of a glass portion 115-2 using any suitable technique, such as an optical glue. The assembly of FIG. 12B may be manufactured using any suitable technique, including, for example, conventional package substrate manufacturing techniques, as described above with reference to FIG. 6 and/or FIG. 7.

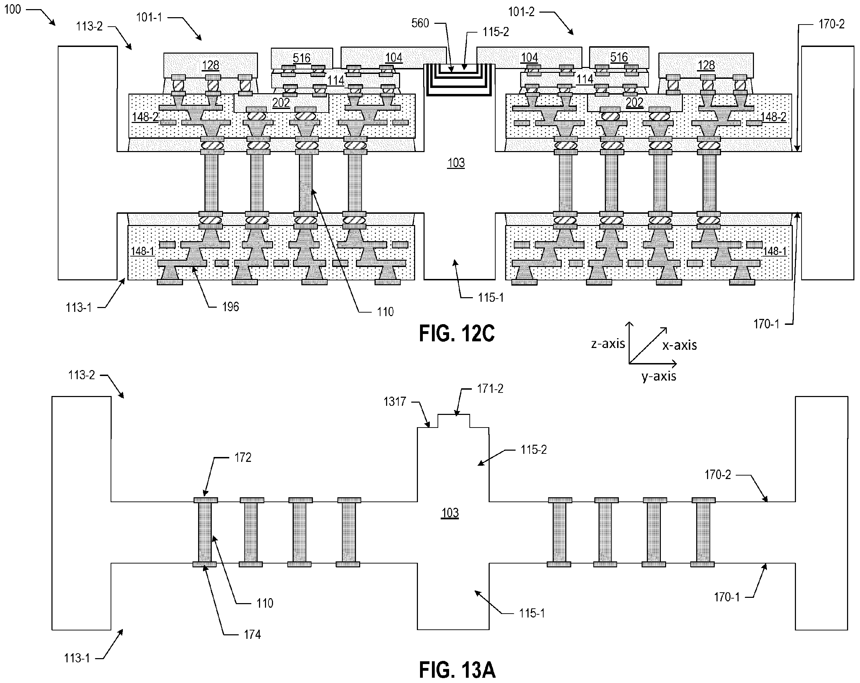

FIG. 12C illustrates an assembly subsequent to forming an optical pathway 560 between PIC 104 of the subassembly 101-1 and PIC 104 of the subassembly 101-2 through the glass portion 115-2. The optical pathway 560 may be formed by any suitable technique, including by laser direct writing. In some embodiments, the optical pathway 560 may be formed prior to attaching PIC 104 and the PIC 104 may be optically aligned to the optical pathway 560 prior to attaching. The assembly of FIG. 12C may itself be a microelectronic assembly 100, as shown. Further manufacturing operations may be performed on the microelectronic assembly 100 of FIG. 12C to form other microelectronic assemblies 100; for example, performing surface finishing operations, such as depositing solder resist, depositing solder 136 at a bottom surface of the first substrate 148-1, attaching a circuit board 131 to a bottom surface of the microelectronic assembly 100 of FIG. 12C by forming interconnects 190, similar to FIG. 1. Although FIG. 12 shows a microelectronic assembly 100 having two subassemblies 101, a microelectronic assembly 100 may have any suitable number of subassemblies 101 and multiple microelectronic assemblies 100 may be manufactured together and subsequently may undergo a singulation process, as described above with reference to FIG. 3.

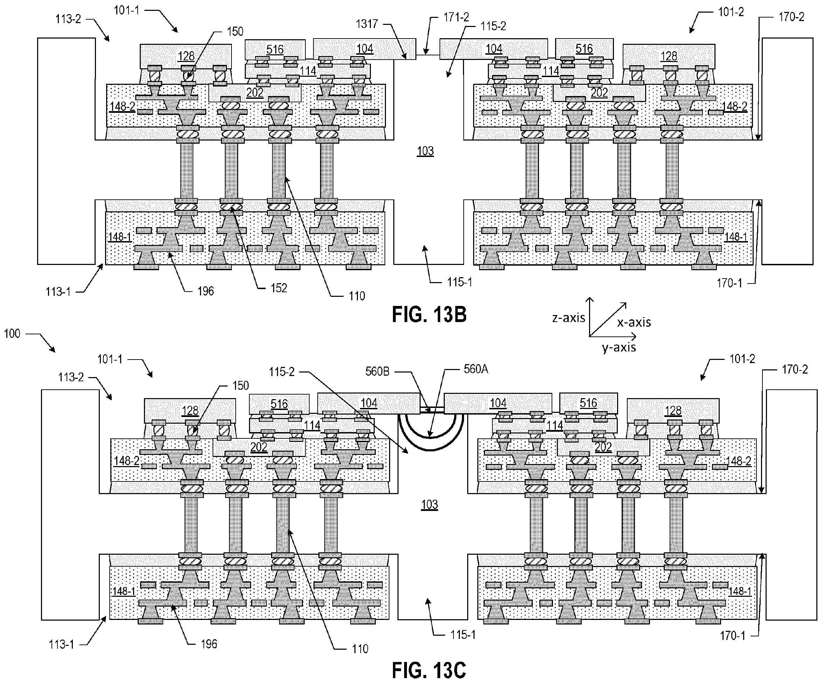

FIGS. 13A-13C are side, cross-sectional views of various stages in an example process for manufacturing the microelectronic assembly 100 of FIG. 5B, in accordance with various embodiments. FIG. 13A illustrates an assembly including a core 103 with cavities 113-1, 113-2, TGVs 110 extending through the core 103 between first and second surfaces 170-1, 170-2 of the core 103, and a cutout 1317 (e.g., a notch) at a top surface 171-2 of a glass portion 115-2. The cutout 1317 may be formed using any suitable technique, including lithography, laser assisted wet etch, laser drilling (e.g., laser ablation using excimer laser), or plasma etching. The cutout 1317 may have any suitable shape for setting a PIC 104 into the cutout 1317 (e.g., as shown in FIG. 13B). The assembly of FIG. 13A may be manufactured using any suitable technique, for example, as described above with reference to FIG. 6 and/or FIG. 7.

FIG. 13B illustrates an assembly subsequent to forming substrates 148-1, 148-2 on respective first and second surfaces 170-1, 170-2 of the core 103, forming interconnects 152, embedding bridge die 202 in the second substrate 148-2, attaching EIC die 114 and XPU 128 to a top surface of the second substrate 148-2 by forming interconnects 150, and attaching microprocessor die 516 and PIC 104 to a top surface of EIC die 114 by forming interconnects 150. PIC 104 may have a planar bottom surface and may be optically coupled to the cutout 1317 on the top surface 171-2 of a glass portion 115-2 using any suitable technique, such as an optical glue. The assembly of FIG. 13B may be manufactured using any suitable technique, including, for example, conventional package substrate manufacturing techniques, as described above with reference to FIG. 6 and/or FIG. 7.

FIG. 13C illustrates an assembly subsequent to forming an optical pathway 560A, 560B between PIC 104 of the subassembly 101-1 and PIC 104 of the subassembly 101-2 through the glass portion 115-2. The optical pathway 560A, 560B may be formed by any suitable technique, including by laser direct writing. In some embodiments, the optical pathway 560A, 560B may be formed prior to attaching PIC 104 and the PIC 104 may be optically aligned to the optical pathway 560A, 560B prior to attaching. The assembly of FIG. 13C may itself be a microelectronic assembly 100, as shown. Further manufacturing operations may be performed on the microelectronic assembly 100 of FIG. 13C to form other microelectronic assemblies 100; for example, performing surface finishing operations, such as depositing solder resist, depositing solder 136 at a bottom surface of the first substrate 148-1, attaching a circuit board 131 to a bottom surface of the microelectronic assembly 100 of FIG. 13C by forming interconnects 190, similar to FIG. 1. Although FIG. 13 shows a microelectronic assembly 100 having two subassemblies 101, a microelectronic assembly 100 may have any suitable number of subassemblies 101 and multiple microelectronic assemblies 100 may be manufactured together and subsequently may undergo a singulation process, as described above with reference to FIG. 3.

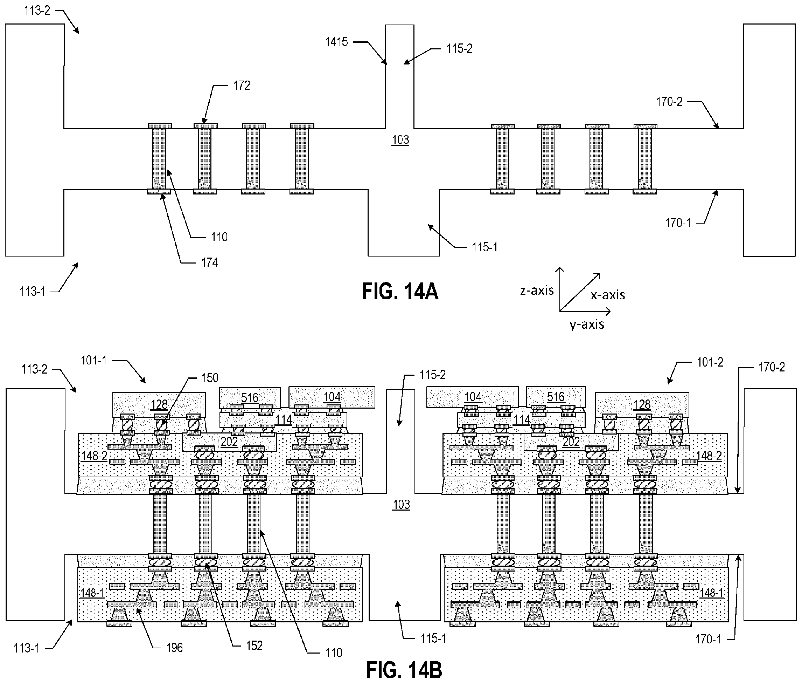

FIGS. 14A-14D are side, cross-sectional views of various stages in an example process for manufacturing the microelectronic assembly 100 of FIG. 5D, in accordance with various embodiments. FIG. 14A illustrates an assembly including a core 103 with cavities 113-1, 113-2, and TGVs 110 extending through the core 103 between first and second surfaces 170-1, 170-2 of the core 103, where the cavity 113-1 and the cavity 113-2 have different dimensions (e.g., cavity 113-2 has a greater y-dimension or width, such that a glass portion 115-2 is narrower than glass portion 115-1). The glass portion 115-2 may be narrowed using any suitable technique, including lithography, laser assisted wet etch, laser drilling (e.g., laser ablation using excimer laser), or plasma etching when forming the cavities 113-2 (e.g., as described above with reference to FIG. 6), or may be a narrower when glass portion 715-2 is attached and bonded to a core 103, as described above with reference to FIG. 7. The assembly of FIG. 14A may be manufactured using any suitable technique, for example, as described above with reference to FIG. 6 and/or FIG. 7.

FIG. 14B illustrates an assembly subsequent to forming substrates 148-1, 148-2 on respective first and second surfaces 170-1, 170-2 of the core 103, forming interconnects 152, embedding bridge die 202 in the second substrate 148-2, attaching EIC die 114 and XPU 128 to a top surface of the second substrate 148-2 by forming interconnects 150, and attaching microprocessor die 516 and PIC 104 to a top surface of EIC die 114 by forming interconnects 150. The assembly of FIG. 14B may be manufactured using any suitable technique, including, for example, conventional package substrate manufacturing techniques, as described above with reference to FIG. 6 and/or FIG. 7.

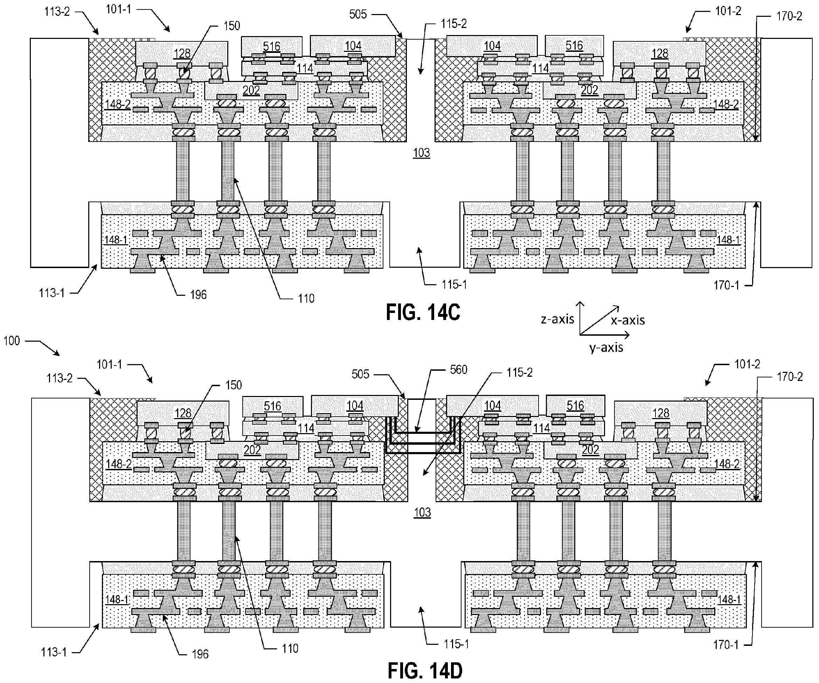

FIG. 14C illustrates an assembly subsequent to depositing an optical polymer 505 in the cavity 113-2 and around the substrate 148-2, XPU 128, EIC die 114, microprocessor die 516, and PIC 104. The optical polymer 505 may be deposited using any suitable technique, such as spin coating, spray coating, or slit coating. In some embodiments, the optical polymer 505 may be cured subsequent to deposition. In some embodiments, the optical polymer may completely cover the substrate 148-2, XPU 128, EIC die 114, microprocessor die 516, and PIC 104.

FIG. 14D illustrates an assembly subsequent to forming an optical pathway 560 between PIC 104 of the subassembly 101-1 and PIC 104 of the subassembly 101-2 through the optical polymer 505 and the glass portion 115-2. The optical pathway 560 may be formed by any suitable technique, including by laser direct writing. The assembly of FIG. 14D may itself be a microelectronic assembly 100, as shown. Further manufacturing operations may be performed on the microelectronic assembly 100 of FIG. 14D to form other microelectronic assemblies 100; for example, performing surface finishing operations, such as depositing solder resist, depositing solder 136 at a bottom surface of the first substrate 148-1, attaching a circuit board 131 to a bottom surface of the microelectronic assembly 100 of FIG. 14D by forming interconnects 190, similar to FIG. 1. Although FIG. 14 shows a microelectronic assembly 100 having two subassemblies 101, a microelectronic assembly 100 may have any suitable number of subassemblies 101 and multiple microelectronic assemblies 100 may be manufactured together and subsequently may undergo a singulation process, as described above with reference to FIG. 3.

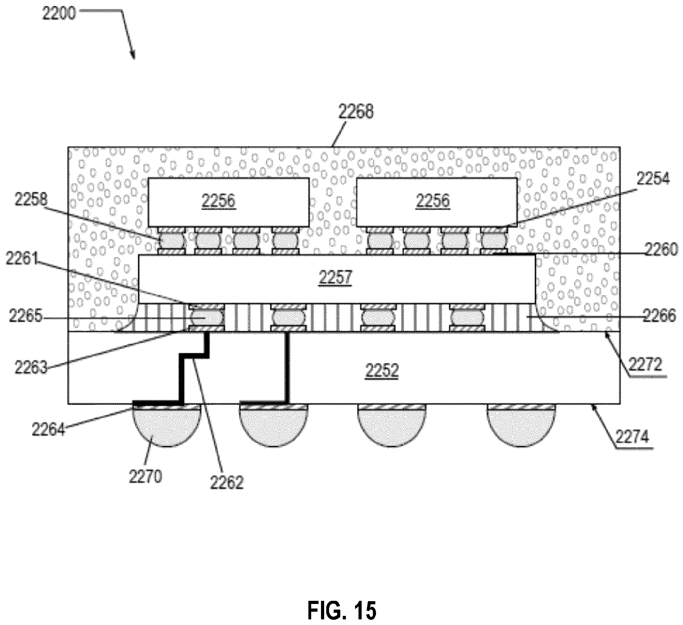

The packages disclosed herein, e.g., any of the microelectronic assemblies 100, or any further embodiments described herein, may be included in any suitable electronic component. FIGS. 15-17 illustrate various examples of packages, assemblies, and devices that may be used with or include any of the IC packages as disclosed herein.

FIG. 15 is a side, cross-sectional view of an example IC package 2200 that may include microelectronic assemblies in accordance with any of the embodiments disclosed herein. In some embodiments, the IC package 2200 may be a system-in-package (SiP).

As shown in FIG. 15, package support 2252 may be formed of an insulator (e.g., a ceramic, a buildup film, an epoxy film having filler particles therein, etc.), and may have conductive pathways extending through the insulator between first face 2272 and second face 2274, or between different locations on first face 2272, and/or between different locations on second face 2274. These conductive pathways may take the form of any of the interconnect structures including lines and/or vias, e.g., as discussed above with reference to FIG. 1.

Package support 2252 may include conductive contacts 2263 that are coupled to conductive pathway 2262 through package support 2252, allowing circuitry within dies 2256 and/or interposer 2257 to electrically couple to various ones of conductive contacts 2264 (or to other devices included in package support 2252, not shown).

IC package 2200 may include interposer 2257 coupled to package support 2252 via conductive contacts 2261 of interposer 2257, first level interconnects (FLI) 2265, and conductive contacts 2263 of package support 2252. FLI 2265 illustrated in FIG. 15 are solder bumps, but any suitable FLI 2265 may be used, such as solder bumps, solder posts, or bond wires.

IC package 2200 may include one or more dies 2256 coupled to interposer 2257 via conductive contacts 2254 of dies 2256, FLI 2258, and conductive contacts 2260 of interposer 2257. In various embodiments, interposer 2257 may include core 103 including glass as described herein. Conductive contacts 2260 may be coupled to conductive pathways (not shown) through interposer 2257, allowing circuitry within dies 2256 to electrically couple to various ones of conductive contacts 2261 (or to other devices included in interposer 2257, not shown). FLI 2258 illustrated in FIG. 15 are solder bumps, but any suitable FLI 2258 may be used, such as solder bumps, solder posts, or bond wires. As used herein, a "conductive contact" may refer to a portion of electrically conductive material (e.g., metal) serving as an interface between different components; conductive contacts may be recessed in, flush with, or extending away from a surface of a component, and may take any suitable form (e.g., a conductive pad or socket).

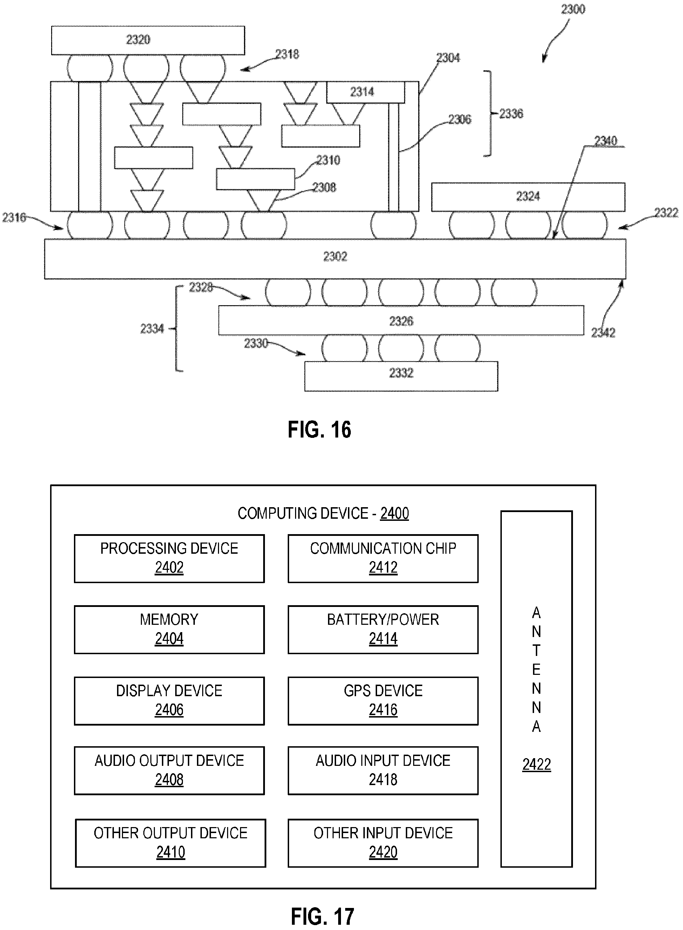

In some embodiments, underfill material 2266 may be disposed between package support 2252 and interposer 2257 around FLI 2265, and mold 2268 may be disposed around dies 2256 and interposer 2257 and in contact with package support 2252. In some embodiments, underfill material 2266 may be the same as mold 2268. Example materials that may be used for underfill material 2266 and mold 2268 are epoxies as suitable. Second level interconnects (SLI) 2270 may be coupled to conductive contacts 2264. SLI 2270 illustrated in FIG. 15 are solder balls (e.g., for a ball grid array (BGA) arrangement), but any suitable SLI 2270 may be used (e.g., pins in a pin grid array arrangement or lands in a land grid array arrangement). SLI 2270 may be used to couple IC package 2200 to another component, such as a circuit board (e.g., a motherboard), an interposer, or another IC package, as known in the art and as discussed below with reference to FIG. 17.

In embodiments in which IC package 2200 includes multiple dies 2256, IC package 2200 may be referred to as a multichip package (MCP). Dies 2256 may include circuitry to perform any desired functionality. For example, besides one or more of dies 2256 including components of dies 114 as described herein, one or more of dies 2256 may be logic dies (e.g., silicon-based dies), one or more of dies 2256 may be memory dies (e.g., high-bandwidth memory), etc. In some embodiments, at least some of dies 2256 may not include components of dies 114 as described herein.

Although IC package 2200 illustrated in FIG. 15 is a flip-chip package, other package architectures may be used. For example, IC package 2200 may be a BGA package, such as an embedded wafer-level ball grid array (eWLB) package. In another example, IC package 2200 may be a wafer-level chip scale package (WLCSP) or a panel fan-out (FO) package. Although two dies 2256 are illustrated in IC package 2200, IC package 2200 may include any desired number of dies 2256. IC package 2200 may include additional passive components, such as surface-mount resistors, capacitors, and inductors disposed over first face 2272 or second face 2274 of package support 2252, or on either face of interposer 2257. More generally, IC package 2200 may include any other active or passive components known in the art.

FIG. 16 is a cross-sectional side view of an IC device assembly 2300 that may include components having one or more microelectronic assembly 100 in accordance with any of the embodiments disclosed herein. IC device assembly 2300 includes a number of components disposed over a circuit board 2302 (which may be, e.g., a motherboard). IC device assembly 2300 includes components disposed over a first face 2340 of circuit board 2302 and an opposing second face 2342 of circuit board 2302; generally, components may be disposed over one or both faces 2340 and 2342. In particular, any suitable ones of the components of IC device assembly 2300 may include any of the one or more microelectronic assembly 100 in accordance with any of the embodiments disclosed herein; e.g., any of the IC packages discussed below with reference to IC device assembly 2300 may take the form of any of the embodiments of IC package 2200 discussed above with reference to FIG. 15.

In some embodiments, circuit board 2302 may be a PCB including multiple metal layers separated from one another by layers of insulator and interconnected by electrically conductive vias. Any one or more of the metal layers may be formed in a desired circuit pattern to route electrical signals (optionally in conjunction with other metal layers) between the components coupled to circuit board 2302. In other embodiments, circuit board 2302 may be a non-PCB package support.

FIG. 16 illustrates that, in some embodiments, IC device assembly 2300 may include a package-on-interposer structure 2336 coupled to first face 2340 of circuit board 2302 by coupling components 2316. Although not shown so as not to clutter the drawing, package-on-interposer structure 2336 may include a core 103, such as glass layer, in some embodiments. In other embodiments, package-on-interposer structure 2336 may not include a core. Coupling components 2316 may electrically and mechanically couple package-on-interposer structure 2336 to circuit board 2302, and may include solder balls (as shown), male and female portions of a socket, an adhesive, an underfill material, and/or any other suitable electrical and/or mechanical coupling structure.

Package-on-interposer structure 2336 may include IC package 2320 coupled to interposer 2304 by coupling components 2318. In some embodiments, IC package 2320 may include microelectronic assembly 100, and other components as described herein, which are not shown so as not to clutter the drawing. Coupling components 2318 may take any suitable form depending on desired functionalities, such as the forms discussed above with reference to coupling components 2316. In some embodiments, IC package 2320 may be or include IC package 2200, e.g., as described above with reference to FIG. 15.

Although a single IC package 2320 is shown in FIG. 16, multiple IC packages may be coupled to interposer 2304; indeed, additional interposers may be coupled to interposer 2304. Interposer 2304 may provide an intervening package support used to bridge circuit board 2302 and IC package 2320. Generally, interposer 2304 may redistribute a connection to a wider pitch or reroute a connection to a different connection. For example, interposer 2304 may couple IC package 2320 to a BGA of coupling components 2316 for coupling to circuit board 2302.

In the embodiment illustrated in FIG. 16, IC package 2320 and circuit board 2302 are attached to opposing sides of interposer 2304. In other embodiments, IC package 2320 and circuit board 2302 may be attached to a same side of interposer 2304. In some embodiments, three or more components may be interconnected by way of interposer 2304.

Interposer 2304 may be formed of an epoxy resin, a fiberglass reinforced epoxy resin, a ceramic material, or a polymer material such as polyimide. In some implementations, interposer 2304 may be formed of alternate rigid or flexible materials that may include the same materials described above for use in a semiconductor substrate, such as silicon, germanium, and other group III-V and group IV materials. Interposer 2304 may include metal interconnects 2308 and vias 2310, including TSVs 2306. Interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on interposer 2304. Package-on-interposer structure 2336 may take the form of any of the package-on-interposer structures known in the art.

In some embodiments, IC device assembly 2300 may include an IC package 2324 coupled to first face 2340 of circuit board 2302 by coupling components 2322. Coupling components 2322 may take the form of any of the embodiments discussed above with reference to coupling components 2316, and IC package 2324 may take the form of any of the embodiments discussed above with reference to IC package 2320.

In some embodiments, IC device assembly 2300 may include a package-on-package structure 2334 coupled to second face 2342 of circuit board 2302 by coupling components 2328. Package-on-package structure 2334 may include an IC package 2326 and an IC package 2332 coupled together by coupling components 2330 such that IC package 2326 is disposed between circuit board 2302 and IC package 2332. Coupling components 2328 and 2330 may take the form of any of the embodiments of coupling components 2316 discussed above, and IC packages 2326 and/or 2332 may take the form of any of the embodiments of IC package 2320 discussed above. Package-on-package structure 2334 may be configured in accordance with any of the package-on-package structures known in the art.

FIG. 17 is a block diagram of an example computing device 2400 that may include one or more components having one or more IC packages in accordance with any of the embodiments disclosed herein. For example, any suitable ones of the components of computing device 2400 may include microelectronic assembly 100 including glass in accordance with any of the embodiments disclosed herein. In another example, any one or more of the components of computing device 2400 may include any embodiments of IC package 2200 (e.g., as shown in FIG. 15). In yet another example, any one or more of the components of computing device 2400 may include an IC device assembly 2300 (e.g., as shown in FIG. 16).

A number of components are illustrated in FIG. 17 as included in computing device 2400, but any one or more of these components may be omitted or duplicated, as suitable for the application. In some embodiments, some or all of the components included in computing device 2400 may be attached to one or more motherboards. In some embodiments, some or all of these components are fabricated onto a single SOC die.

Additionally, in various embodiments, computing device 2400 may not include one or more of the components illustrated in FIG. 17, but computing device 2400 may include interface circuitry for coupling to the one or more components. For example, computing device 2400 may not include a display device 2406, but may include display device interface circuitry (e.g., a connector and driver circuitry) to which display device 2406 may be coupled. In another set of examples, computing device 2400 may not include an audio input device 2418 or an audio output device 2408, but may include audio input or output device interface circuitry (e.g., connectors and supporting circuitry) to which audio input device 2418 or audio output device 2408 may be coupled.

Computing device 2400 may include a processing device 2402 (e.g., one or more processing devices). As used herein, the term "processing device" or "processor" may refer to any device or portion of a device that processes electronic data from registers and/or memory to transform that electronic data into other electronic data that may be stored in registers and/or memory. Processing device 2402 may include one or more digital signal processors (DSPs), ASICs, CPUs, GPUs, cryptoprocessors (specialized processors that execute cryptographic algorithms within hardware), server processors, or any other suitable processing devices. Computing device 2400 may include a memory 2404, which may itself include one or more memory devices such as volatile memory (e.g., dynamic random access memory (DRAM)), nonvolatile memory (e.g., read-only memory (ROM)), flash memory, solid state memory, and/or a hard drive. In some embodiments, memory 2404 may include memory that shares a die with processing device 2402. This memory may be used as cache memory and may include embedded dynamic random access memory (eDRAM) or spin transfer torque magnetic random access memory (STT-MRAM).

In some embodiments, computing device 2400 may include a communication chip 2412 (e.g., one or more communication chips; note that the terms "chip," "die," and "IC die" are used interchangeably herein). For example, communication chip 2412 may be configured for managing wireless communications for the transfer of data to and from computing device 2400. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

Communication chip 2412 may implement any of a number of wireless standards or protocols, including Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 2412 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). Communication chip 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives of it, as well as any other wireless protocols that are designated as 3G, 4G, 5G, and beyond. Communication chip 2412 may operate in accordance with other wireless protocols in other embodiments. Computing device 2400 may include an antenna 2422 to facilitate wireless communications and/or to receive other wireless communications (such as AM or FM radio transmissions).

In some embodiments, communication chip 2412 may manage wired communications, such as electrical, optical, or any other suitable communication protocols (e.g., the Ethernet). As noted above, communication chip 2412 may include multiple communication chips. For instance, a first communication chip 2412 may be dedicated to shorter-range wireless communications such as Wi-Fi or Bluetooth, and a second communication chip 2412 may be dedicated to longer-range wireless communications such as global positioning system (GPS), EDGE, GPRS, CDMA, WiMAX, LTE, EV-DO, or others. In some embodiments, a first communication chip 2412 may be dedicated to wireless communications, and a second communication chip 2412 may be dedicated to wired communications.

Computing device 2400 may include battery/power circuitry 2414. Battery/power circuitry 2414 may include one or more energy storage devices (e.g., batteries or capacitors) and/or circuitry for coupling components of computing device 2400 to an energy source separate from computing device 2400 (e.g., AC line power).

Computing device 2400 may include a display device 2406 (or corresponding interface circuitry, as discussed above). Display device 2406 may include any visual indicators, such as a heads-up display, a computer monitor, a projector, a touchscreen display, a liquid crystal display (LCD), a light-emitting diode display, or a flat panel display, for example.

Computing device 2400 may include audio output device 2408 (or corresponding interface circuitry, as discussed above). Audio output device 2408 may include any device that generates an audible indicator, such as speakers, headsets, or earbuds, for example.

Computing device 2400 may include audio input device 2418 (or corresponding interface circuitry, as discussed above). Audio input device 2418 may include any device that generates a signal representative of a sound, such as microphones, microphone arrays, or digital instruments (e.g., instruments having a musical instrument digital interface (MIDI) output).

Computing device 2400 may include a GPS device 2416 (or corresponding interface circuitry, as discussed above). GPS device 2416 may be in communication with a satellite-based system and may receive a location of computing device 2400, as known in the art.

Computing device 2400 may include other output device 2410 (or corresponding interface circuitry, as discussed above). Examples of other output device 2410 may include an audio codec, a video codec, a printer, a wired or wireless transmitter for providing information to other devices, or an additional storage device.

Computing device 2400 may include other input device 2420 (or corresponding interface circuitry, as discussed above). Examples of other input device 2420 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

Computing device 2400 may have any desired form factor, such as a handheld or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, computing device 2400 may be any other electronic device that processes data.

The above description of illustrated implementations of the disclosure, including what is described in the abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize.

The following paragraphs provide various examples of the embodiments disclosed herein.

Example 1 provides a microelectronic assembly, including a glass layer having a first surface and a second surface opposite the first surface; a first dielectric layer on the first surface of the glass layer, the first dielectric layer including a first lateral surface and a second lateral surface opposite the first lateral surface; a second dielectric layer on the second surface of the glass layer, the second dielectric layer including a third lateral surface and a fourth lateral surface opposite the third lateral surface; a first glass portion on the first surface of the glass layer at the first lateral surface of the first dielectric layer; a second glass portion on the first surface of the glass layer at the second lateral surface of the first dielectric layer; a third glass portion on the second surface of the glass layer at the third lateral surface; and a fourth glass portion on the second surface of the glass layer at the fourth lateral surface.

Example 2 provides the microelectronic assembly of example 1, where a thickness of the glass layer is between 50 microns and 2 millimeters.

Example 3 provides the microelectronic assembly of example 1 or 2, where a thickness of the first glass portion is between 50 microns and 2 millimeters.

Example 4 provides the microelectronic assembly of any one of examples 1-3, where a thickness of the second glass portion is between 50 microns and 2 millimeters.

Example 5 provides the microelectronic assembly of any one of examples 1-4, further including through-glass vias (TGVs) in the glass layer including a conductive material; a first conductive pathway in the first dielectric layer electrically coupled to at least one of the TGVs; and a second conductive pathway in the second dielectric layer electrically coupled to at least one of the TGVs.

Example 6 provides the microelectronic assembly of example 5, further including a die on the second dielectric layer and electrically coupled to the second conductive pathway in the second dielectric layer.

Example 7 provides the microelectronic assembly of example 6, further including an interconnect die at least partially within the second dielectric layer and electrically coupled to the die.

Example 8 provides the microelectronic assembly of any one of examples 5-7, further including a circuit board at the first dielectric layer and electrically coupled to the first conductive pathway.

Example 9 provides the microelectronic assembly of example 6 or 7, further including an insulating material surrounding the die.

Example 10 provides a microelectronic assembly, including a glass layer having a first surface and an opposing second surface, the glass layer including: a first cavity in the first surface; a second cavity in the second surface; and a through-glass via (TGV) extending through the glass layer between a top surface of the first cavity and a bottom surface of the second cavity, the TGV including a conductive material; a first dielectric in the first cavity, the first dielectric including a first conductive pathway electrically coupled to the TGV; and a second dielectric in the second cavity, the second dielectric including a second conductive pathway electrically coupled to the TGV.

Example 11 provides the microelectronic assembly of example 10, where an overall thickness of the glass layer is between 50 microns and 2 millimeters.

Example 12A. The microelectronic assembly of claim 10, where a thickness of the first cavity is between 5 microns and 120 microns.

Example 12B. The microelectronic assembly of claim 10, where a thickness of the second cavity is between 5 microns and 120 microns.

Example 12C. The microelectronic assembly of claim 10, where a thickness of the glass layer between the first cavity and the second cavity is between 50 microns and 1.2 millimeters.

Example 13 provides the microelectronic assembly of example 10 or 11, where the first conductive pathway is electrically coupled to the TGV by a first interconnect including solder and the second conductive pathway is electrically coupled to the TGV by a second interconnect including solder.

Example 14 provides the microelectronic assembly of example 13, further including a first underfill material around the first interconnect and between the first dielectric and the top surface of the first cavity; and a second underfill material around the second interconnect and between the second dielectric and the bottom surface of the second cavity.

Example 15 provides the microelectronic assembly of any one of examples 10-14, further including an insulating material in the second cavity around the second dielectric.

Example 16 provides the microelectronic assembly of any one of examples 10-15, further including a die on the second dielectric and electrically coupled to the second conductive pathway in the second dielectric.

Example 17 provides the microelectronic assembly of example 16, where the die is a first die and the second conductive pathway in the second dielectric is one of a plurality of second conductive pathways, and the microelectronic assembly further including a second die on the second dielectric and electrically coupled to one of more of the second conductive pathways in the second dielectric.

Example 18 provides the microelectronic assembly of example 17, further including an interconnect die at least partially within the second dielectric and electrically coupled to the first die and the second die.

Example 19 provides the microelectronic assembly of example 18, further including a circuit board at the first dielectric and electrically coupled to the first conductive pathway.

Example 20 provides a microelectronic assembly, including a first layer including a first dielectric, a third dielectric, and a first glass portion between the first dielectric and the third dielectric; a second layer including a second dielectric, a fourth dielectric, and a second glass portion between the second dielectric and the fourth dielectric; and a third layer between the first layer and the second layer, the third layer including a bulk glass material, and where the first layer physically couples to a first surface of the third layer and the second layer physically couples to a second surface of the third layer.

Example 21 provides the microelectronic assembly of example 20, where a thickness of the third layer is between 50 microns and 2 millimeters.

Example 22 provides the microelectronic assembly of example 20 or 21, where a thickness of the first layer is between 50 microns and 2 millimeters.

Example 23 provides the microelectronic assembly of any one of examples 20-22, where a thickness of the second layer is between 50 microns and 2 millimeters.

Example 24 provides the microelectronic assembly of any one of examples 20-23, further including through-glass vias (TGVs) in the third layer through the glass bulk material including a conductive material; a first conductive pathway in the first dielectric electrically coupled to at least one of the TGVs; a second conductive pathway in the second dielectric electrically coupled to at least one of the TGVs; a third conductive pathway in the third dielectric electrically coupled to at least one of the TGVs; and a fourth conductive pathway in the fourth dielectric electrically coupled to at least one of the TGVs.

Example 25 provides the microelectronic assembly of example 24, further including a first die on the second dielectric and electrically coupled to the second conductive pathway in the second dielectric; and a second die on the fourth dielectric and electrically coupled to the fourth conductive pathway in the fourth dielectric.

Example 26 provides the microelectronic assembly of example 25, further including a fifth dielectric on the second glass portion between the second dielectric and the fourth dielectric; and a fifth conductive pathway through the fifth dielectric electrically coupling the first die and the second die.

Example 27 provides the microelectronic assembly of example 25 or 26, further including a substrate at the first layer, the substrate including conductive pathways electrically coupled to the first conductive pathway in the first dielectric and electrically coupled to the third conductive pathway in the third dielectric, where the first die is electrically coupled to the second die by the conductive pathways in the substrate, the first conductive pathway, and the third conductive pathway.

Example 28 provides the microelectronic assembly of any one of examples 25-27, where the first die is one of a plurality of first dies and the second die is one of a plurality of second dies, and the microelectronic assembly further including a first interconnect die at least partially within the second dielectric and electrically coupled to at least two of the plurality of first dies; and a second interconnect die at least partially within the fourth dielectric and electrically coupled to at least two of the plurality of second dies.

Example 29 provides the microelectronic assembly of example 28, further including a first insulating material surrounding the plurality of first dies and a second insulating material surrounding the plurality of second dies.

Example 30 provides the microelectronic assembly of any one of examples 24-29, further including a first photonic integrated circuit (PIC) on the second dielectric, the first PIC electrically coupled to the second conductive pathway in the second dielectric; and a second PIC on the fourth dielectric, the second PIC electrically coupled to the fourth conductive pathway in the fourth dielectric, where the second PIC is optically coupled to the first PIC by an optical pathway through the second glass portion between the second dielectric and the fourth dielectric.

Example 31 provides the microelectronic assembly of example 30, where the optical pathway includes a waveguide.

Example 32 provides the microelectronic assembly of example 31, where the waveguide is a laser written waveguide.

Example 33 provides the microelectronic assembly of any one of examples 30-32, further including a first electrical integrated circuit (EIC) die and a first processor integrated circuit (XPU) conductively coupled to the first PIC and the second conductive pathway in the second dielectric; and a second EIC die and a second XPU conductively coupled to the second PIC and the fourth conductive pathways in the fourth dielectric.

Example 34 provides a microelectronic assembly, including a first layer including a first dielectric, a third dielectric, and a first glass portion between the first dielectric and the third dielectric; a second layer including a second dielectric, a fourth dielectric, and a second glass portion between the second dielectric and the fourth dielectric; and a third layer between the first layer and the second layer, the third layer including a bulk glass material, and where: the first layer physically couples to a first surface of the third layer and the second layer physically couples to a second surface of the third layer; and the first glass portion includes a first undercut adjacent to the first dielectric and a second undercut adjacent to the third dielectric.

Example 35 provides the microelectronic assembly of example 34, where the second glass portion further includes a third undercut at the second surface of the third layer adjacent to the second dielectric and a fourth undercut at the second surface of the third layer adjacent to the fourth dielectric.

Example 36 provides the microelectronic assembly of example 34 or 35, where the first glass portion frames the first dielectric and the third dielectric, and the second glass portion frames the second dielectric and the fourth dielectric.

Example 37 provides the microelectronic assembly of example 36, where the first dielectric is one of a plurality of first dielectrics, the third dielectric is one of a plurality of third dielectrics, and the first glass portion is one of a plurality of first glass portions, and where the second dielectric is one of a plurality of second dielectrics, the fourth dielectric is one of a plurality of fourth dielectrics, and the second glass portion is one of a plurality of second glass portions.

Example 38 provides the microelectronic assembly of any one of examples 34-37, further including a first material on a surface of the first glass portion, where the surface of the first glass portion is opposite the third layer, and where the first material includes an adhesive material or a mold material; and a second material on the first material on the surface of the first glass portion, where the second material includes a conductive material having a thickness between 10 microns and 70 microns.

Example 39 provides the microelectronic assembly of example 38, further including the first material on a surface of the second glass portion, where the surface of the second glass portion is opposite the third layer; and the second material on the first material on the surface of the second glass portion.

Example 40 provides the microelectronic assembly of example 39, where the first glass portion frames the first dielectric and the third dielectric, and the second glass portion frames the second dielectric and the fourth dielectric.

Example 41 provides the microelectronic assembly of example 40, where the first dielectric is one of a plurality of first dielectrics, the third dielectric is one of a plurality of third dielectrics, and the first glass portion is one of a plurality of first glass portions, and where the second dielectric is one of a plurality of second dielectrics, the fourth dielectric is one of a plurality of fourth dielectrics, and the second glass portion is one of a plurality of second glass portions.

Example 42 provides the microelectronic assembly of any one of examples 34-41, where the third layer includes a plurality of through glass vias (TGVs), and the first dielectric includes a first conductive pathway electrically coupled to at least one of the plurality of TGVs, the second dielectric includes a second conductive pathway electrically coupled to at least one of the plurality of TGVs, the third dielectric includes a third conductive pathway electrically coupled to at least one of the plurality of TGVs, and the fourth dielectric includes a fourth conductive pathway electrically coupled to at least one of the plurality of TGVs.

Example 43 provides the microelectronic assembly of example 42, further including a die on the first dielectric and electrically coupled to the first conductive pathway by an interconnect.

Example 44 provides the microelectronic assembly of example 43, where the die is a first die and the interconnect is a first interconnect, and the microelectronic assembly further includes a second die at least partially within the first dielectric and electrically coupled to the first die by a second interconnect.

Example 45 provides the microelectronic assembly of example 44, further including a third die electrically coupled to the second die by a third interconnect.

Example 46 provides the microelectronic assembly of example 45, further including an insulating material surrounding the first die and the third die.

Example 47 provides a microelectronic assembly, including a glass layer having a first surface and an opposing second surface, the glass layer including: a first cavity in the first surface, the first cavity having a first undercut along sidewalls of the first cavity; a second cavity in the second surface, the second cavity having a second undercut along sidewalls of the second cavity; and a through-glass via (TGV) extending through the glass layer between a top surface of the first cavity and a bottom surface of the second cavity, the TGV including a conductive material; a first dielectric in the first cavity, the first dielectric including a first conductive pathway electrically coupled to the TGV; and a second dielectric in the second cavity, the second dielectric including a second conductive pathway electrically coupled to the TGV.

## Claims

1. A microelectronic assembly, comprising:
a glass layer having a first surface and an opposing second surface, the glass layer including:
a first cavity in the first surface;
a second cavity in the second surface; and
a through-glass via (TGV) extending through the glass layer between a top surface of the first cavity and a bottom surface of the second cavity, the TGV including a conductive material;
a first dielectric in the first cavity, the first dielectric including a first conductive pathway electrically coupled to the TGV; and
a second dielectric in the second cavity, the second dielectric including a second conductive pathway electrically coupled to the TGV.

2. The microelectronic assembly of claim 1, wherein an overall thickness of the glass layer is between 50 microns and 2 millimeters.

3. The microelectronic assembly of claim 1, wherein an overall thickness of the glass layer is between 150 microns and 6 millimeters.

4. The microelectronic assembly of any one of claims 1-3, wherein the first conductive pathway is electrically coupled to the TGV by a first interconnect and the second conductive pathway is electrically coupled to the TGV by a second interconnect.

5. The microelectronic assembly of claim 4, wherein the first interconnect and the second interconnect include solder, and the microelectronic assembly further comprising:
a first underfill material around the first interconnect and between the first dielectric and the top surface of the first cavity; and
a second underfill material around the second interconnect and between the second dielectric and the bottom surface of the second cavity.

6. An integrated circuit (IC) package, comprising:
a first layer including a first dielectric, a third dielectric, and a first glass portion between the first dielectric and the third dielectric;
a second layer including a second dielectric, a fourth dielectric, and a second glass portion between the second dielectric and the fourth dielectric; and
a third layer between the first layer and the second layer, the third layer including a bulk glass material, and wherein the first layer physically couples to a first surface of the third layer and the second layer physically couples to a second surface of the third layer.

7. The IC package of claim 6, wherein a thickness of the third layer is between 50 microns and 2 millimeters.

8. The IC package of claim 6 or 7, further comprising:
through-glass vias (TGVs) in the third layer through the glass bulk material including a conductive material;
a first conductive pathway in the first dielectric electrically coupled to at least one of the TGVs;
a second conductive pathway in the second dielectric electrically coupled to at least one of the TGVs;
a third conductive pathway in the third dielectric electrically coupled to at least one of the TGVs;
a fourth conductive pathway in the fourth dielectric electrically coupled to at least one of the TGVs;
a first die on the second dielectric and electrically coupled to the second conductive pathway in the second dielectric; and
a second die on the fourth dielectric and electrically coupled to the fourth conductive pathway in the fourth dielectric.

9. The IC package of claim 8, further comprising:
a fifth dielectric on the second glass portion between the second dielectric and the fourth dielectric; and
a fifth conductive pathway through the fifth dielectric electrically coupling the first die and the second die.

10. The IC package of claim 8 or 9, further comprising:
a substrate at the first layer, the substrate including conductive pathways electrically coupled to the first conductive pathway in the first dielectric and electrically coupled to the third conductive pathway in the third dielectric, wherein the first die is electrically coupled to the second die by the conductive pathways in the substrate, the first conductive pathway, and the third conductive pathway.

11. The IC package of any one of claims 8-10, further comprising:
a first photonic integrated circuit (PIC) on the second dielectric, the first PIC electrically coupled to the second conductive pathway in the second dielectric; and
a second PIC on the fourth dielectric, the second PIC electrically coupled to the fourth conductive pathway in the fourth dielectric, wherein the second PIC is optically coupled to the first PIC by an optical pathway through the second glass portion between the second dielectric and the fourth dielectric.

12. The IC package of claim 11, further comprising:
a first electrical integrated circuit (EIC) die and a first processor integrated circuit (XPU) conductively coupled to the first PIC and the second conductive pathway in the second dielectric; and
a second EIC die and a second XPU conductively coupled to the second PIC and the fourth conductive pathways in the fourth dielectric.

13. A substrate, comprising:
a first layer including a first dielectric, a third dielectric, and a first glass portion between the first dielectric and the third dielectric;
a second layer including a second dielectric, a fourth dielectric, and a second glass portion between the second dielectric and the fourth dielectric; and
a third layer between the first layer and the second layer, the third layer including a bulk glass material, and wherein:
the first layer physically couples to a first surface of the third layer and the second layer physically couples to a second surface of the third layer; and
the first glass portion includes a first undercut adjacent to the first dielectric and a second undercut adjacent to the third dielectric.

14. The substrate of claim 13, further comprising:
a first material on a surface of the first glass portion, wherein the surface of the first glass portion is opposite the third layer, and wherein the first material includes an adhesive material or a mold material; and
a second material on the first material on the surface of the first glass portion, wherein the second material includes a conductive material having a thickness between 10 microns and 70 microns.

15. The substrate of claim 14, further comprising:
the first material on a surface of the second glass portion, wherein the surface of the second glass portion is opposite the third layer; and
the second material on the first material on the surface of the second glass portion.
